# EUROPÄISCHE PATENTSCHRIFT

(11) **EP 2 890 485 B1**
(45) Veröffentlichungstag und Bekanntmachung des Hinweises auf die Patenterteilung: **02.06.2021**
(21) Anmeldenummer: 13753331.1
(22) Anmeldetag: 29.08.2013
(51) Int. Cl.: B01J 13/02, B01J 19/24, B82Y 40/00

(54) **VERFAHREN ZUR HERSTELLUNG VON KERN/SCHALE-NANOPARTIKELN UND KERN-SCHALE-NANOPARTIKEL**
METHOD FOR PRODUCING CORE/SHELL NANOPARTICLES AND CORE/SHELL NANOPARTICLES
PROCÉDÉ DE PRÉPARATION DE NANOPARTICULES NOYAU/ENVELOPPE ET NANOPARTICULES NOYAU/ENVELOPPE

(30) Priorität: 30.08.2012 DE 102012215421
(43) Veröffentlichungstag der Anmeldung: 08.07.2015
(73) Patentinhaber: Fraunhofer-Gesellschaft zur Förderung der angewandten Forschung e.V., 80686 München (DE)
(72) Erfinder: SCHMIDTKE-TRAN, Van Huong, 83278 Traunstein (DE); NIEHAUS, Steffen, Jan, 21465 Wentorf (DE); WELLER, Horst, 22393 Hamburg (DE); NESS, Daniel, 22083 Hamburg (DE)
(74) Vertreter: Beckmann, Claus
(86) Internationale Anmeldenummer: PCT/EP2013/067898
(87) Internationale Veröffentlichungsnummer: WO 2014/033213

(56) Entgegenhaltungen:
- EP-A2- 1 284 159
- WO-A1-2009/101091
- US-A1- 2003 017 264
- US-A1- 2005 129 580
- US-A1- 2007 128 350
- PING YANG ET AL: "Highly Luminescent CdSe/Cd x Zn 1- x S Quantum Dots with Narrow Spectrum and Widely Tunable Wavelength", JOURNAL OF PHYSICAL CHEMISTRY C, Bd. 115, Nr. 30, 4. August 2011 (2011-08-04), Seiten 14455-14460, XP055103201, ISSN: 1932-7447, DOI: 10.1021/jp201214k
- TALAPIN D V ET AL: "Highly luminescent monodisperse CdSe and CdSe/ZnS nanocrystals synthesized in HEXADECYLAMINE-TRIOCTYLPHOSPHINE OXIDE-TRIOCTYLPHOSPINE MIXTURE", NANO LETTERS, AMERICAN CHEMICAL SOCIETY, US, Bd. 1, Nr. 4, 16. März 2001 (2001-03-16), Seiten 207-211, XP002235569, ISSN: 1530-6984, DOI: 10.1021/NL0155126

## Beschreibung

Die vorliegende Erfindung betrifft ein neues Verfahren zur Herstellung von Kern/Schale-Nanopartikeln und die nach diesem Verfahren erhältlichen Kern-Schale-Nanopartikel. Ebenso betrifft die Erfindung die Verwendung eines Röhrenreaktors zur kontinuierlichen Herstellung dieser Kern/Schale-Nanopartikeln.

### Technischer Hintergrund

In den letzten Jahren hat das Studium von Nanopartikeln großes Interesse aufgrund der einzigartigen Eigenschaften von Nanopartikeln erfahren. Die physikalischen Eigenschaften von Nanopartikeln unterscheiden sich grundsätzlich von denen des entsprechenden makroskopischen Materials. Diese unterschiedlichen physikalischen Eigenschaften der Nanopartikel sind auf die reduzierte Größe der Nanopartikel zurückzuführen, die zwischen jener einer makroskopischen Substanz und der molekularen Größenordnung liegt. Der Unterschied in den physikalischen Eigenschaften zwischen dem Grundmaterial (bulk material) und einem nanopartikulären Material ist auf die Zunahme im Verhältnis Oberfläche/Volumen und die Größe der Nanopartikel zurückzuführen, die sich auf eine Größenordnung zu bewegt, in der Quanteneffekte dominieren können. Das mit den kleiner werdenden Nanopartikeln zunehmende Verhältnis Oberfläche/Volumen führt zu einem zunehmenden Einfluss der Atome auf der Oberfläche des Nanopartikels gegenüber den Atomen, die sich im Inneren des Nanopartikels befinden.

Das Quanteneffekt-Phänomen beeinflusst nicht nur die Eigenschaften des Nanopartikels für sich betrachtet, sondern auch die Eigenschaften des Nanopartikels in seiner Wechselwirkung mit anderen Materialien. Daher haben Nanopartikel großes Interesse in Bereichen der Forschung erfahren, in denen eine große Oberfläche erforderlich ist, beispielsweise auf dem Gebiet der Katalyse oder bei der Anwendung in Elektroden, Halbleitern, optischen Vorrichtungen und Brennstoffzellen.

Derzeit existieren verschiedene Verfahren für die Herstellung von Nanopartikeln. Hierzu zählen die Gasphasenabscheidung, die Nasschemische Synthese und das Mahlen des entsprechenden makroskopischen Materials.

US 2003/017264 A1 offenbart Verfahren zur Synthese von lumineszierenden Nanopartikeln sowie mit diesen Verfahren hergestellte Nanopartikel.

EP 1 284 159 A2 offenbart einen Rohrreaktor auf Basis eines Schichtstoffes.

US 2005/129580 A1 offenbart mikrofluidische Module zur Herstellung von nanokristallinen Materialien in einem kontinuierlichen Fließverfahren.

Die WO 2009/101091 betrifft eine Vorrichtung für die Herstellung von Nanopartikeln umfassend: mindestens ein Modul zur Lösungszubereitung, mindestens ein Modul zur Partikelsynthese, das drei unabhängig voneinander heizbare Kammern umfasst, worin mindestens das eine Modul zur Lösungszubereitung in Serie mit mindestens dem einen Modul zur Partikelsynthese geschaltet ist.

Diese internationale Anmeldung offenbart auch ein Verfahren zur Herstellung von Nanopartikeln, welches die folgenden Schritte umfasst: die Herstellung von mindestens zwei Lösungen von Partikelausgangsstoffen, das getrennte und im Wesentlichen gleichzeitige Vorheizen der mindestens zwei Lösungen der Partikelausgangsstoffe bei einer ersten Temperatur, wobei diese erste Temperatur mindestens die Nukleationstemperatur der Partikel beträgt, das Mischen der mindestens zwei Lösungen der Partikelausgangsstoffe bei einer zweiten Temperatur, wobei die zweite Temperatur im Wesentlichen die gleiche ist wie die erste Temperatur, unter Bildung der Nanopartikel, das Wachsen der Partikel bei einer dritten Temperatur, wobei die dritte Temperatur weniger beträgt als die erste Temperatur.

Beispiel 4 dieser Anmeldung betrifft die Herstellung von CdSe-CdS Kern-Schale-Nanopartikeln nach diesem Verfahren.

Die Passivierung von CdSe-Kernen oder anderen Halbleiter-Nanopartikeln durch ein anorganisches Schalenmaterial ist ein bekanntes Verfahren, die Stabilität der Teilchen und ihre über die Quantenausbeute messbare Leuchteffizienz zu erhöhen. Beispielsweise ist es bekannt, CdSe-Nanopartikel entweder mit CdS oder mit ZnS-Schalenmaterial zu beschichten, da die Bandlücke von CdSe kleiner ist als bei CdS oder ZnS und somit sichergestellt werden kann, dass fotogenerierte Elektronen und Löcher primär auf das Kernmaterial CdSe beschränkt sind. Einen Nachteil bei der Herstellung solcher, nur aus Kern- und Schalenmaterial aufgebauten Nanopartikeln besteht jedoch in den Gitterspannungen, die sich daraus ergeben, dass die Gitterkonstanten von Kern- und Schalenmaterial nicht übereinstimmen. Dieser Unterschied in den Gitterkonstanten beträgt beispielsweise 3,9 % für CdSe gegenüber CdS und 12 % für CdSe gegenüber ZnS. Diese Gitterspannungen können sich nachteilig auf die Quantenausbeute auswirken und ferner zur Bildung von Teilchen mit unregelmäßiger Form führen.

Kern/Schale-Nanopartikel werden beispielsweise in den folgenden Schriften erwähnt oder näher beschrieben:
US 7,144,458 B2 (flow synthesis of quantum dot nanocrystals), US 2003/0017264 A1 (luminescent nanoparticles and methods for their preparation), US 6,207,229 B1 (highly luminescent color-selective materials and methods of making thereof);
Peng X., et al. "Epitaxial growth of highly luminescent CdSe/CdS core/shell nanocrystals with photostability and electronic accessibility", J.Am.Chem.Soc. 1997, 119, 7019-7029; Farmer, S. C. and Patten, T. E., Photoluminescent polymer/quantum dot composite nanoparticles. Chem. Mater. 2001, 13, 3920-3926 betreffend Kern/Schale-CdS/SiO₂-Nanopartikel; US 2006/0028882 A1 (Alloyed semiconductor nanocrystals); DE 10131173 A1 (Verfahren zur Herstellung eines Kern-Hülle-Teilchens, wobei der Kern ein nanoscaliges Teilchen ist); Ping Yang et al. (Highly luminescent CdSe/CdxZn1-xS quantum dots with narrow spectrum and widely tunable wavelength), J. Phys. Chem. C 2011, 115, 14455-14460.
Huiguang Zhu et al., Low temperature synthesis of ZnS and CdZnS shells on CdSe quantum dots, Nanotechnology 21 (2010) 255604 lehrt, dass die Quantenausbeute von CdSe-Kern-Nanokristallen sich von 10 auf 36 % bzw. von 10 auf 40 % in CdSe/ZnS und CdSe/CdZnS-Kern/Schale-Nanokristallen erhöht.

Renguo Xie et al. beschreiben in J. Am. Chem. Soc. 2005, 127, 7480-7488, die Synthese und Charakterisierung von stark lumineszenten mehrschaligen Kern-Schale-Nanokristallen, die einen CdSe-Kern und eine CdS/Zn_{0.5}Cd_{0.5}S/ZnS-Schale aufweisen. Die Autoren verwenden hierfür die sog. SILAR Methode nach J. J. Li et al. (J. Am. Chem. Soc., 2003, 125, 12567-12575). In einem nicht kontinuierlichen Verfahren wurden 3 ml ODE (1-Octadecene) und 1 g ODA (Octadecylamin) in ein 50ml Reaktionsgefäß gegeben und dann mit den CdSe-Kernpartikeln in Hexan vermischt und auf 100 °C erhitzt. Die Ausgangsstoffe für das Schalenmaterial werden dann so zugegeben, um 2 Monoschichten CdS, 3,5 Monoschichten Zn_{0.5}Cd_{0.5}S und zwei Monoschichten ZnS aufwachsen zu lassen.

Die Autoren behaupten, dass aufgrund dieser stufenweisen Änderung der Zusammensetzung die resultierenden Nanopartikel eine hohe Kristallinität aufweisen. Angeblich konnten Quantenausbeuten von 70-85 % für Amin-stabilisierte Mehrschalenpartikel in organischen Lösungsmitteln und eine Quantenausbeute von bis zu 50 % für Mercaptopropionsäurestabilisierte Teilchen in Wasser erzielt werden.

WO 2003/092043 beschreibt lumineszierende Kern/Schalepartikel, die eine Übergangszone aufweisen können, die ein Additiv enthält, das man unter Cd, Se, Te, S, In, P, As, Pb, O, Si und Al auswählt. Beispiel 1 beschreibt z.B. ein Herstellungsvefahren von CdSe/ZnS-Kern/Schalepartikeln, bei dem man zu den CdSe-Kernen das Additv Cd (als Dimethylcadmium) gibt, bevor man die ZnS-Schale aufwachsen lässt. WO 2003/092043 lehrt jedoch nicht, wie man eine Übergangszone herstellen kann, die nur aus Kern- und Schalenmaterial besteht und gegenläufige Gradienten für Kern- und Schalenmaterial aufweist.

Führt man die Synthese von Kern/Schale-NPs nach einem Batchverfahren durch, wie z.B. nach dem Verfahren von Xie et al. oder gemäß WO 2003/092043, stellt man üblicherweise von Charge zu Charge Variationen in den Produkteigenschaften fest, die man minimieren möchte, um dem Käufer der NPs möglichst einheitliche Produktqualität garantieren zu können. Sowohl das von Renguo Xie et al. beschriebene Verfahren als auch das Verfahren der WO 2003/092043 sind zur Herstellung größerer Mengen an Kern-Schale-Nanopartikeln nicht geeignet und können auch nicht kontinuierlich durchgeführt werden. Das Verfahren nach Xie et al. ist ferner sehr umständlich, da es die genaue Berechnung und Dosierung der Ausgangsmaterialien für die Schalen erfordert.

Es wäre wünschenswert, neue und einfache aufgebaute Kern-Schale-Nanopartikel bereitzustellen, in denen auf andere Weise die Gitterspannungen zwischen dem gewünschten Kernmaterial und dem gewünschten äußeren Schalenmaterial verringert werden können.

Ein Nachteil vieler Nanopartikel (NP)-Synthesen ist es ferner, dass es neben dem Wachstum dieser NP zur Bildung neuer NP-Kristallisationskeime ("Nukleation") kommt. Das Ergebnis sind NP-Dispersionen mit sehr breiter Größenverteilung. Gerade bei der Synthese von Kern/Schale- NP ist es besonders wichtig, diese ungewollte Nukleation zu unterdrücken. Ansonsten bilden sich aus den Ausgangsstoffen für das Schalenmaterial neben der Schale um den Kern herum neue NP aus Schalenmaterial, die oft nicht mehr aus der Produktmischung abzutrennen sind.

Angesichts des zuvor beschriebenen Stands der Technik, wäre es wünschenswert, Kern/Schale-Nanopartikel mit einer sehr engen bzw. engeren Teilchengrößenverteilung zu erzielen.

Es ist eine Aufgabe der vorliegenden Erfindung, ein neues Verfahren zur Herstellung von Kern/Schale-NP bereitzustellen, das die ungewollte Nukleation während des Schalewachstums unterdrückt.

Es ist eine weitere Aufgabe der vorliegenden Erfindung, ein neues Verfahren zur Herstellung von Kern/Schale-NP bereitzustellen, das zu einer sehr engen Teilchengrößenverteilung führt.

Es ist eine weitere Aufgabe der vorliegenden Erfindung, ein neues Verfahren zur Herstellung von Kern/Schale-NPs bereitzustellen, das auch bei wiederholter Durchführung des Verfahrens zu NP mit sehr homogenen Produkteigenschaften führt.

Es ist eine weitere Aufgabe der vorliegenden Erfindung, bevorzugtermaßen in enger Teilchengrößenverteilung, neue Kern/Schale-NP bereitzustellen, in denen die Gitterspannung zwischen dem gewünschten Kernmaterial und dem gewünschten Schalenmaterial minimiert wird.

Es ist eine weitere Aufgabe der vorliegenden Erfindung, Kern/Schale-NP mit ausgezeichneten Lumineszenzeigenschaften, z.B. einer sehr guten Quantenausbeute, bereitzustellen.

Schließlich ist es Aufgabe der Erfindung, die Verwendung eines Röhrenreaktors zur kontinuierlichen Herstellung von Kern/Schale-Nanopartikeln bereitzustellen, der bei Erzielung der erfindungsgemäßen Vorteile eine reaktionstechnisch und wirtschaftlich optimale Durchführung des oben genannten Verfahrens erlaubt.

### Darstellung der Erfindung

Die Erfindung betrifft ein Verfahren zur kontinuierlichen Herstellung von Kern/Schale-Nanopartikeln, die einen Kern aus einem Kernmaterial, vorzugsweise aus einem ersten Halbleitermaterial, und eine Schale aus einem Schalenmaterial umfassen, vorzugsweise aus einem zweiten Halbleitermaterial,
wobei das Verfahren die folgenden Schritte umfasst:
a) das Herstellen einer Dispersion von Nanopartikeln aus dem Kernmaterial (z.B. CdSe) in einem Lösungsmittel,
b) das Bereitstellen aller Ausgangsstoffe für das Schalenmaterial (z.B. CdZnS), vorzugsweise in gelöster Form,
c) die Auswahl von einem oder mehreren Ausgangsstoffen für das Schalenmaterial für das Vermischen in Schritt d), wobei die Auswahl so erfolgt, dass die ausgewählten Ausgangsstoffe nicht untereinander reagieren (wenn mehr als ein Ausgangsstoff ausgewählt wird), beispielsweise durch Auswahl aller Ausgangsstoffe für die Metallkomponenten des Schalenmaterials, oder durch die Auswahl aller Ausgangsstoffe für die Nichtmetallkomponenten des Schalenmaterials,
d) das Vermischen des ausgewählten Ausgangsstoffs oder der ausgewählten Ausgangsstoffe für das Schalenmaterial (z.B. Cd-Lösung und Zn-Lösung) mit der Dispersion der Nanopartikel aus dem Kernmaterial (z.B. CdSe),
e) das kontinuierliche Führen der in Schritt d) erhaltenen Mischung durch eine Reaktionszone (10) eines Röhrenreaktors,
f) das kontinuierliche Zuführen der in Schritt c nicht ausgewählten Ausgangsstoffes oder der nicht ausgewählten Ausgangsstoffe für das Schalenmaterial (z.B. S-Lösung) an zwei oder mehr Stellen zu der Reaktionszone (10),
g) das Reagieren der Ausgangsstoffe für das Schalenmaterial in der Reaktionszone (10) unter Bildung einer Schale um die Nanopartikel aus dem Kernmaterial,
und wobei die Reaktionszone (10) des Röhrenreaktors von einer Membran (7) umgeben wird, über die in Schritt f) die in Schritt c) nicht ausgewählten ein oder mehrere Ausgangsstoffe für das Schalenmaterial zugeführt werden,
worin die Kern-Schale-Nanopartikel zwischen Kern und Schale eine Übergangszone aufweisen, die nur aus den Komponenten des Kern- und den Komponenten des Schalenmaterials besteht, und in welcher in Richtung der Schale der Anteil des Kernmaterials allmählich abnimmt und gleichzeitig der Anteil des Schalenmaterials allmählich zunimmt, und worin die in Schritt a) hergestellte Dispersion von Partikeln aus dem Kernmaterial mindestens einen Ausgangsstoff für das Kernmaterial enthält.

Weitere bevorzugte Ausführungsformen sind wie in den Ansprüchen definiert.

Vorzugsweise sind sowohl das Kernmaterial als auch das Schalenmaterial aus Metallen und Nichtmetallen aufgebaut, und das Verfahren umfasst die folgenden Schritte:
a) das Herstellen einer Dispersion von Nanopartikeln aus dem Kernmaterial, vorzusweise einem Halbleiter wie CdSe oder ZnS in einem Lösungsmittel,
b) das Bereitstellen aller Ausgangsstoffe für das Schalenmaterial, vorzusweise einem zweiten Halbleiter wie ZnS oder CdZnS, vorzugsweise in gelöster Form,
c) die Auswahl von einem oder mehreren Ausgangsstoffen für die Metallkomponenten des Schalenmaterials oder die Auswahl von einem oder mehreren Ausgangsstoffen für die Nichtmetallkomponente) des Schalenmaterial für das Vermischen in Schritt d),
d) das Vermischen des ausgewählten Ausgangsstoffs oder der ausgewählten Ausgangsstoffe für das Schalenmaterial (z.B. Cd-Lösung und Zn-Lösung) mit der Dispersion der Nanopartikel aus dem Kernmaterial (z.B. CdSe),
e) das kontinuierliche Führen der in Schritt d) erhaltenen Mischung durch eine Reaktionszone (10) eines Röhrenreaktors,
f) das kontinuierliche Zuführen des in Schritt c) nicht ausgewählten Ausgangsstoffes oder der in Schritt c) nicht ausgewählten Ausgangsstoffe für das Schalenmaterial (z.B. S-Lösung) an zwei oder mehr Stellen zu der Reaktionszone (10),
g) das Reagieren der Ausgangsstoffe für das Schalenmaterial in der Reaktionszone (10) unter Bildung einer Schale um die Nanopartikel aus dem Kernmaterial.

In Schritt f) führt man somit einen oder mehrere Ausgangsstoffe für die Metallkomponenten des Schalenmaterials oder einen oder mehrere Ausgangsstoffen für die Nichtmetallkomponenten kontinuierlich zu, je nachdem, ob in Schritt d) die Ausgangsstoffe für die Nichtmetallkomponenten oder die Metallkomponenten zu der Dispersion der Nanopartikel aus dem Kernmaterial beigemischt wurde.

Gemäß der Erfindung weisen die Kern-Schale-Nanopartikel zwischen Kern und Schale eine Übergangszone auf, die nur aus den Komponenten des Kern- und den Komponenten des Schalenmaterials besteht, und in welcher der Anteil des Kernmaterials allmählich in Richtung der Schale abnimmt und gleichzeitig der Anteil des Schalenmaterials allmählich zunimmt. Zur Ausbildung dieser Übergangszone enthält die in Schritt a) hergestellte Dispersion von Partikeln aus dem Kernmaterial mindestens einen Ausgangsstoff für das Kernmaterial. Die Anwesenheit eines Ausgangsstoff für das Kernmaterial genügt dann zur Ausbildung einer Übergangszone, wenn der oder die anderen Ausgangsstoffe für das Kernmaterial über die Ausgangsstoffe für das Schalenmaterial bereitgestellt werden, z.B. weil Kern und Schale die gleiche Metallkomponenten (z.B. Cd) umfassen. Ansonsten wird man in dieser Ausführungsform des Verfahrens darauf achten, dass die in Schritt a) hergestellte Dispersion von Partikeln aus dem Kernmaterial alle Ausgangsstoffe für das Kernmaterial enthält.

Ein weiterer Aspekt der Erfindung betrifft Kern-Schale-Nanopartikel, die einen Kern aus einem Kernmaterial, vorzugsweise einem ersten Halbleitermaterial, und eine äußere Schale aus einem Schalenmaterial umfassen, vorzugsweise aus einem zweiten Halbleitermaterial, dadurch gekennzeichnet, dass sich zwischen Kern und Schale nur eine Schicht aus einer Übergangszone befindet, die nur aus den Komponenten des Kern- und den Komponenten des Schalenmaterials besteht, und in welcher in Richtung der Schale der Anteil des Kernmaterials allmählich abnimmt und gleichzeitig der Anteil des Schalenmaterials allmählich zunimmt, wobei der mittlere Durchmesser der Übergangszone von 0,1 bis 5 nm beträgt.

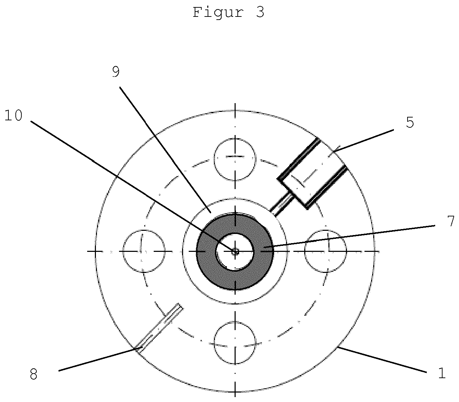

Gemäß einem weiteren Aspekt der Erfindung wird die Verwendung eines Röhrenreaktors zur kontinuierlichen Herstellung von Kern/Schale-Nanopartikeln bereitgestellt, wobei der Reaktor einen von einer Wandung (1) umgebenen röhrenförmigen Hohlraum (2) und eine in dem Hohlraum längs (entlang der Flussrichtung) angeordneten Membran (7), welche den Hohlraum in eine Zudosierzone (9) und eine Reaktionszone (10) unterteilt, aufweist (siehe Figur 3), wobei der Reaktor an einem Ende eine in die Reaktionszone (10) führende Zuleitung (4a) für Mischungen aus Ausgangsmaterial für die Schale und Kernpartikeldispersion und am anderen Ende einen aus der Reaktionszone (10) herausführende Ableitung (4b) für gebildete Kern-/Schale-Nanopartikel aufweist. Der Röhrenreaktor, der gemäß der Erfindung verwendet wird, ist dadurch gekennzeichnet, dass entlang des Hohlraums in der Wandung (1) mindestens ein Anschluss (5) für die Zugabe weiteren Ausgangsmaterials für die Schale vorgesehen ist, der in der Zudosierzone (9) mündet.

Die längs im Hohlraum, also entlang der röhrenförmigen Erstreckung angeordnete Membran und die dadurch geschaffenen, durch die Membran getrennten, ebenfalls entlang des Hohlraums orientierten Zudosier- und Reaktionszonen (9,10) erlauben eine graduelle, entlang des gesamten Hohlraums erfolgende Reaktion der zugegebenen weiteren Schalenausgangsmaterialien mit der Mischung aus weiterem Ausgangsmaterial für die Schale und Kernpartikeldispersion. Da die Mischung von einem Ende des Röhrenreaktors in die Reaktionszone eingeführt wird und das in der Zudosierzone befindliche, zugegebene Ausgangsmaterial entlang der gesamten Länge des Hohlraums durch die Membran strömt, erlaubt dies eine in Flussrichtung der Mischung zunehmende Konzentration von Schalenausgangsmaterial in zumindest einem Teil der Reaktionszone, bei vorzugsweise gleichbleibender Konzentration von Kernen (ohne Schale oder mit wachsender Schale). Vorzugsweise steht in der Reaktionszone nur eine verhältnismäßig geringe Konzentration an Ausgangsstoffen für das Schalenmaterial zur Verfügung, welche bevorzugt durch Schalenbildung abreagiert. Die Bildung neuer Kerne aus Schalenmaterial ("Nukleation") wird auf diese Weise unterdrückt und das zugeführte Schalenausgangsmaterial in Flussrichtung der Mischung dient allein dem weiteren Aufbau der Schale.

Da die in Schritt a) hergestellte Dispersion von Partikeln aus dem Kernmaterial mindestens einen Ausgangsstoff für das Kernmaterial enthält, kommt es in den Nanopartikeln zur Ausbildung eines graduellen Übergangs vom Kern zur Schale, wodurch die Gitterspannung zwischen dem gewünschten Kernmaterial und dem gewünschten Schalenmaterial minimiert wird.

### Beschreibung der Figuren

Fig. 1 zeigt einen Längsquerschnitt durch einen Röhrenreaktor (ohne Membran), mit dem das erfindungsgemäße Verfahren vorteilhaft durchgeführt werden kann.
Fig. 2 zeigt die röhrenförmige Membran, welche in den Kanal des Röhrenreaktors eingepasst wird.
Fig. 3 zeigt einen Querschnitt durch den Röhrenreaktor mit Membran.
Fig. 4a bis c zeigen Fotografien des geschlossenen Röhrenreaktors (4a), des geöffneten Röhrenreaktors mit herausgezogener Membran (4b), und einer für den Röhrenreaktor entwickelten Heizmanschette.

### Detaillierte Beschreibung der Erfindung

Die vorliegende Erfindung betrifft ein Verfahren zur kontinuierlichen Herstellung von Kern/Schale-Nanopartikeln, die einen Kern aus einem Kernmaterial, vorzugsweise einem ersten Halbleitermaterial, und eine Schale aus einem Schalenmaterial, vorzugsweise einem zweiten Halbleitermaterial umfassen.

Der Ausdruck Nanopartikel bezieht sich auf eine maximale mittlere Ausdehnung (Durchmesser) der Partikel im Nanometerbereich, d. h. unterhalb 1µm. Bevorzugtermaßen beträgt der mittlere Durchmesser jedoch 100 nm oder weniger, insbesondere weniger als 50 nm.

Die Begriffe "Schale" und "Schalenmaterial" beziehen sich auf die äußerste Schicht des Partikels. Kern und Schale liegen üblicherweise in kristalliner Form vor. Zwischen Kern und Schale liegt eine später erläuterte Übergangsschicht mit gegenläufigen Konzentrationsgradienten des Kern- und Schalenmaterials vor. Der Kern/Schale-Nanopartikel kann ferner mit einer Hülle organischer Stabilisatormoleküle umgeben sein, welche die Agglomeration der einzelnen Nanopartikel verhindert. Auch dieser Stabilisator wird später näher erläutert.

Kern und Schale der Nanopartikel sind vorzugsweise aus einem ersten bzw. einem zweiten Halbleitermaterial aufgebaut. Vorzugsweise werden die Halbleitermaterialien unter II-VI, III-V oder IV-VI-Verbindungen ausgewählt. Aus Gründen der Kompatibilität wählt man oft das erste und zweite Halbleitermaterial so aus, dass beide zur gleichen Verbindungsklasse, d.h. II-VI, III-V oder IV-VI gehören. Es ist jedoch auch möglich, einen III-V-Kern mit einer II-VI (z.B. aus ZnS) oder IV-VI-Schale zu umgeben.

Darüber hinaus erfolgt die Auswahl vorzugsweise bei allen Kombinationen von Kern- und Schalenmaterial so, dass Kern- und Schalenmaterial die gleiche Gitterstruktur aufweisen und vorzugsweise die Gitterkonstanten sich möglichst ähnlich sind. Die bedeutet für die einander entsprechenden Gitterkonstanten des Kern- und des Schalenmaterials, dass die größere von der kleineren Gitterkonstante vorzugsweise nicht mehr als 30%, stärker bevorzugt nicht mehr als 15%, noch stärker bevorzugt nicht mehr als 10% abweicht. Ein weiteres Auswahlkriterium, das vorzugsweise hinzukommt, ist, dass man das Kern- und Schalenmaterial unter Halbleitermaterialien (vorzugsweise II-VI, III-V oder IV-VI) so auswählt, dass die Bandlücke des Kernmaterials kleiner ist als die Bandlücke des Schalenmaterials.

Beispiele für geeignete III-V Verbindungen sind AlP, AlAs, AlSb, AlN, GaP, GaAs, GaSb, InP, InAs, InSb, InN, AlGaN, AlGaP, AlGaS, GaInAs, GaInN, GaInP und andere III-V Verbindungen, die zwei oder mehrere der Elemente Al, Ga und In mit N, P, As oder Sb verbinden.

Unter den III-V Halbleitermaterialien wählt man das Kern- und das Schalenmaterial vorzugsweise so aus, dass die Bandlücke des Kernmaterials kleiner ist, als die Bandlücke des Schalenmaterials, so dass die fotogenerierten Elektronen und Löcher hauptsächlich auf den Kern beschränkt sind. Das III-V-Kernmaterial kann auch mit 0,1 bis 10 mol-%, bezogen auf den Gesamtgehalt an Metallen, mit Übergangsmetallen oder Seltenerdmetallen, z. B. Mn, Co und Eu dotiert werden. Dies gilt auch für das III-V-Schalenmaterial.

Die II-VI-Verbindungen können beispielsweise unter CdS, CdSe, CdTe, ZnS, ZnSe, ZnTe, MgTe, HgS, HgSe, HgTe, und CdZnS, ausgewählt werden. Bevorzugt ist auch eine Auswahl von II-VI-Verbindungen, in denen zwei oder mehrere der Elemente Zn, Cd und Hg, vorzugsweise Zn und Cd, mit S oder Se kombiniert werden.

Das II-VI- oder IV-IV-Kernmaterial kann ferner mit 0,1 bis 10 mol-%, bezogen auf den Gesamtgehalt der Metallatome, mit Übergangsmetallen oder Seltenerdmetallen, z. B. Mn, Co oder Eu dotiert werden.

Die IV-VI-Verbindungen können beispielsweise unter PbS, PbSe, oder PbTe ausgewählt werden.

Bevorzugten Kombinationen an Kern/Schalenmaterialien sind z.B. CdSe/ZnS oder CdSe/CdZnS.

Nicht-Halbleiter wie SiO₂ können auch als Schalenmaterial eingesetzt werden.

Das erfindungsgemäße Verfahren umfasst zumindest die zuvor und im Folgenden erläuterten Schritte a) bis g). Man sollte verstehen, dass soweit sich dies nicht aus der Definition dieser Schritte zwangsläufig ergibt, die Buchstaben keine zeitliche Reihenfolge festlegen. Beispielsweise kann der Auswahlschritt c) auch vor dem Bereitstellen der Ausgangsstoffe für das Schalenmaterial erfolgen. Gleichermaßen erfolgen aufgrund der kontinuierlichen Verfahrensweise die Schritte d), e), f) und g) normalerweise zeitgleich.

In **Schritt a)** stellt man eine Dispersion von Nanopartikeln aus dem Kernmaterial in einem Lösungsmittel her.

Da die Reaktion vorzugsweise bei atmosphärischem Druck durchgeführt wird (wenn man von dem Druck absieht, der durch das Zudosieren der Ausgangsstoffe, z.B. über ein Pumpe, in Schritt f erzeugt wird), wählt man das Lösungsmittel so aus, dass sein Siedepunkt die gewünschte maximale Reaktionstemperatur deutlich übersteigt, vorzugsweise um mindestens 10K, insbesondere mindestens 30K, mindestens 50K oder sogar mndestens 100K. Die maximale Reaktionstemperatur liegt üblicherweise bei 90 bis 290 °C, vorzugsweise 240 bis 260 °C.

Vorzugsweise wählt man daher Lösungsmittel mit einem Siedepunkt von mindestens 90°C, z.B. mindestens 100 °C, mindestens 150°C, oder mindestens 200°C aus, die man beispielsweise unter Kohlenwasserstoffen, Carboxy-Säuren, phosphororganischen Verbindungen und organischen Verbindungen mit Stickstoff auswählen kann. Die Kohlenwasserstoffe können aromatisch oder aliphatisch sein. Vorzugsweise wählt man ungesättigte aliphatische Kohlenwasserstoffe mit einem Siedepunkt von mindestens 200 °C, vorzugsweise mindestens 250 °C aus, wie Octadecen oder Squalen. Die Carboxy-Säuren sind vorzugsweise aliphatische Carboxy-Säuren mit einem Siedepunkt von mindestens 200 °C, vorzugsweise Alkan- oder Alkensäuren mit 12 bis 20 Kohlenstoffatomen, wie Ölsäure. Bei den phosphororganischen Verbindungen handelt es sich vorzugsweise um Phosphine oder Phosphinoxide mit drei aliphatischen und/oder aromatischen Resten, die einen Siedepunkt von mindestens 200 °C aufweisen, z. B. Trioctylphosphin, Trioctylphosphinoxid oder Triphenylphosphin. Die stickstofforganische Verbindung kann aromatisch oder aliphatisch sein und ist vorzugsweise ein primäres Alkylamin mit einem Siedepunkt von mindestens 200°C, beispielsweise ein C₁₂ bis C₂₀-Alkylamin wie Hexadecylamin oder Oleylamin.

Carboxy-Säuren, phosphororganische und stickstofforganische Lösungsmittel können, wie später erläutert wird, darüber hinaus die Funktion eines Stabilisators erfüllen. Einzelne phosphororganische Verbindungen, wie Trioctylphosphin oder Triphenylphosphin können auch als Ausgangsstoffe für Phosphor dienen.

Die Herstellung der Dispersion der Kern-Nanopartikel erfolgt vorzugsweise gemäß der Lehre der WO 2009/101091 der CAN GmbH. Diese beschreibt in den Beispielen ausschließlich die Herstellung von II-VI Verbindungen. Die Herstellung von IV-VI-Verbindungen kann analog erfolgen oder auf andere, im Stand der Technik beschriebene Weise. Die Herstellung von III-V-Kernpartikeln kann gemäß einer weiteren Anmeldung der CAN GmbH erfolgen, der WO 2009/065639.

Bei der Synthese von II-VI- oder IV-VI-Verbindungen stellt man das Ausgangsmaterial für die VI-Komponente (vorzugsweise ein Chalkogen wie S oder Se) vorzugsweise in einer gelösten Form bereit, beispielsweise durch Lösen von Selen oder Schwefel in einem geeigneten Lösungsmittel, wie Trioctylphosphin. In einer weiteren Ausführungsform ist das Ausgangsmaterial für die VI-Komponente eine Silylverbindung des VI-Elements, beispielsweise Bis(trimethylsilyl)sulfid, welches man in einem geeigneten Lösungsmittel wie Trioctylphosphin löst. Thioharnstoff, der bei erhöhter Temperatur H₂S freisetzt, kann auch verwendet werden. Der Ausgangsstoff für die II- oder die IV-Komponente ist vorzugsweise ein Salz, insbesondere ein organisches Salz des II-Elements, beispielsweise ein Acetat wie Zink- oder Cadmiumacetat, oder ein organisches Salz des IV-Elements wie Bleiacetat.

Zur Herstellung einer stabilen Dispersion der Kernnanopartikel gibt man in der Regel zu der Reaktionsmischung einen Stabilisator hinzu, der in der Literatur auch als "end capping agent" bezeichnet wird. Die Funktion dieses Stabilisators ist es, durch Anlagern an die Partikeloberfläche eine Aggregation einzelner Partikel zu verhindern und den nanopartikulären Zustand zu stabilisieren. Geeignete Stabilisatoren haben eine polare funktionelle Gruppe, die vorzugsweise ein oder mehrere Elemente ausgewählt unter P, N, S und O enthält, beispielsweise eine Phosphin-, Amin-, Thio- oder Carboxygruppe, die an einen oder mehrere organische Reste gebunden sind. Die Kohlenstoffzahl pro organischem Rest beträgt vorzugsweise mindestens drei, vorzugsweise mindestens fünf Kohlenstoffatome. Die Kohlenstoffzahl pro organischem Rest beträgt üblicherweise nicht mehr als 30, insbesondere nicht mehr als 20.

Bestimmte Lösungsmittel wie z. B. Carboxy-Säuren, Phosphine, Amine oder Polyole können gleichzeitig als Stabilisator dienen. Auch Mischungen von zwei oder mehreren Stabilisatoren können verwendet werden.

In **Schritt b)** des erfindungsgemäßen Verfahrens werden nun die Ausgangsstoffe für das Schalenmaterial, vorzugsweise in gelöster Form, bereitgestellt. Vorzugsweise werden alle Ausgangsstoffe für das Schalenmaterial in gelöster Form bereitgestellt. Vorzugsweise erfolgt die Bereitstellung so, dass jeder einzelne Ausgansstoff, d.h. vorzugsweise jede Metallkomponente, aus der das Schalenmaterial aufgebaut ist, und jede Nichtmetallkomponente, aus der das Schalenmaterial aufgebaut ist, einzeln bereitgestellt wird, vorzugsweise in gelöster Form. Mindestens eine Lösung eines Ausgangsstoffs, vorzugsweise alle Lösungen, enthalten einen Stabilisator (wie zuvor beschrieben) der über eine funktionelle Gruppe an die Oberfläche der gebildeten Kern/Schale-Partikel binden kann. Zu beachten ist hier, dass wie erläutert, verschiedene Stabilisatoren, wie Carboxy-Säuren, wie Ölsäure, phosphororganische Verbindungen, z. B. Phosphine; stickstofforganische Verbindungen, z. B. Amine; oder Polyole, z.B. Alkyldiole, Glycerin oder (Poly)ethylenglykol, gleichzeitig als Lösungsmittel dienen können. Wie zuvor in Zusammenhang mit der Kernsynthese beschrieben, verwendet man bei der Herstellung von II-VI- oder IV-VI-Schalenmaterialien z.B. Thioharnstoff, vorzugsweise Silyl-Verbindungen oder die elementare Form der VI-Komponente, vorzugsweise eines Chalkogens wie S oder Se. Schwefel oder Selen können jedoch auch in gasförmiger Form (H₂S bzw. H₂Se) bereitgestellt und in Schritt f) zugeführt werden. Auch hinsichtlich der Auswahl der Ausgangsstoffe für die II- oder IV-Komponenten, der Lösungsmittel und/oder Stabilisatoren kann in vollem Umfang auf die obigen Erläuterungen Bezug genommen werden.

Ein wesentliches Element des erfindungsgemäßen Verfahrens ist, dass nicht alle Ausgangsstoffe für das Schalenmaterial gleichzeitig mit der Dispersion der Kernpartikel vermischt bzw. dieser zugeführt werden. In **Schritt c)** des Verfahrens trifft man daher eine Auswahl, welche Ausgangsstoffe (in Schritt d)) mit der Dispersion der Kernpartikel vermischt werden sollen. Grundsätzlich erfolgt die Auswahl so, dass die ausgewählten Ausgangsstoffe nicht miteinander reagieren, beispielsweise indem man alle Ausgangsstoffe für die Metallkomponenten des Schalenmaterials oder alle Ausgangsstoffe für die Nichtmetallkomponenten des Schalenmaterials für das Vermischen in Schritt d) auswählt.

Der nicht-ausgewählte (übrigbleibende) Ausgangsstoff bzw. die nicht-ausgewählten (übrigbleibenden) Ausgangsstoffe werden in Schritt f) an mehreren Stellen des Röhrenreaktors zudosiert.

Hat man nur zwei Ausgangsstoffe, wie bei binären II-VI-, IV-VI- oder III-V-Verbindungen, kann man entweder die Metallkomponente (II, IV bzw. III) oder die Nichtmetallkomponente (VI bzw. V) in Schritt d) mit der Dispersion der Kernpartikel vermischen. Die vorliegenden Untersuchungen deuten jedoch daraufhin, dass man je nach Art der Partikel gleichmäßigere Kern/Schale-Partikel erhalten kann, wenn man die Metallkomponente in Schritt d) mit den Kernpartikeln vermischt und die Nichtmetallkomponente in Schritt f) an mehreren Stellen der Reaktionszone des Röhrenreaktors, beispielsweise von außen über eine Membran, zuführt.

Bei ternären (z. B. CdZnS) oder quaternären Schalenmaterialien wird man ebenfalls darauf achten, dass die Auswahl der Ausgangsstoffe in Schritt c) so erfolgt, dass die reaktiven Bestandteile getrennt bleiben, um eine vorzeitige Reaktion zu verhindern. Dementsprechend wird man auch hier die Metallkomponenten in Schritt d) vermischen und die Nichtmetallkomponenten in Schritt f) zuführen (bevorzugt) oder umgekehrt.

In **Schritt d)** werden der ausgewählte Ausgangsstoff oder die ausgewählten Ausgangsstoffe für das Schalenmaterial mit der Dispersion der Kernpartikel vermischt. Um möglichst schnell eine homogene Mischung zu erzielen, stellt man daher die Ausgangsstoffe, soweit sie in gelöster Form vorliegen, vorzugsweise im gleichen Lösungsmittel bereit, wie es in der Dispersion der Kernpartikel vorliegt. Vorzugsweise verwendet man auch den gleichen Stabilisator bzw. die gleichen Stabilisatoren, die wie gesagt auch die Funktion des Lösungsmittels übernehmen können. Vorzugsweise vermischt man in Schritt d) mit dem Reaktionsprodukt der Kernpartikelsynthese, ohne die Kernpartikel nach der Synthese zu isolieren oder in sonstiger Weise zu behandeln.

In dem erfindungsgemäßen Verfahren, welches das Erzeugen einer Schicht aus einer Übergangszone zwischen Kern- und Schalenmaterial ermöglicht, enthält das Reaktionsprodukt der Kernpartikelsynthese noch Ausgangsstoffe für das Kernmaterial, welche diese Übergangszone mit aufbauen. Dies wird nachstehend näher erläutert. Ein Abkühlen des Reaktionsprodukts der Kernpartikelsynthese vor dem Schritt d) ist nicht erforderlich, kann jedoch in einer Ausführungsform des Verfahrens vorgenommen werden.

Das Vermischen von Ausgangsstoff(en) für das Schalenmaterial mit der Dispersion der Kernpartikel in Schritt d) erfolgt vorzugsweise vor Eintritt in den Röhrenreaktor. Es ist jedoch auch möglich, wenn auch nicht bevorzugt, die Dispersion der Kernpartikel und die ausgewählten Ausgangsstoffe für das Schalenmaterial dem Röhrenreaktor separat zuzuführen, um diese im Reaktor, aber noch vor der Reaktionszone, homogen zu vermischen.

Die in Schritt d) erhaltene Mischung wird in **Schritt e)** nun kontinuierlich durch eine Reaktionszone eines Röhrenreaktors geführt.

In **Schritt f)** führt man kontinuierlich den/die nicht ausgewählten (verbliebenen) Ausgangsstoff/e für das Schalenmaterial an zwei oder mehreren Stellen der Reaktionszone des Röhrenreaktors zu.

Durch die Zudosierung in Schritt f) kann man erreichen, dass zu Beginn (und im weiteren Verlauf) der Reaktionszone nur eine verhältnismäßig geringe Konzentration an Ausgangsstoffen für das Schalenmaterial zur Verfügung steht und diese bevorzugt durch Schalenbildung abreagiert. Die Bildung neuer Kerne aus Schalenmaterial ("Nukleation") wird auf diese Weise unterdrückt.

Gemäß der Erfindung wird die Reaktionszone des Röhrenreaktors von einer Membran umgeben. In einer bevorzugten Ausführungsform verwendet man einen Röhrenreaktor mit röhrenförmiger Membran, wie er zuvor und im Folgenden beschrieben wird und auch beansprucht wird. In dieser Ausführungsform führt man den bzw. die Ausgangsstoffe für das Schalenmaterial über die Membran in den Hohlraum der Membran zu, welcher die Reaktionszone des Röhrenreaktors bildet. In diesem Fall bezeichnet der Ausdruck "Zufuhr des Schalenausgangsmaterials zur Reaktionszone an zwei oder mehreren Stellen der Reaktionszone" somit die unzähligen Poren ("Stellen") der
Membran, über die das Schalenausgangsmaterial in die Reaktionszone eintritt.

In **Schritt g)** reagieren die Ausgangsstoffe für das Schalenmaterial in der Reaktionszone unter Bildung einer Schale um die Partikel aus dem Kernmaterial. Die Reaktionstemperatur in Schritt g), d.h. in der Reaktionszone des Röhrenreaktors beträgt vorzugsweise mehr als 0 bis 380°C, stärker bevorzugt 25 bis 260 °C, noch stärker bevorzugt 80 bis 200 °C beträgt. Bei der Synthese von CdSe/ZnS, oder CdSe/CdZnS-NP arbeitet man üblicherweise mit 70 bis 250 °C, insbesondere 90 bis 130 °C.

Nach dem Austritt aus der Reaktionszöne kann man die Teilchen zur Reifung in eine Wachstumskammer führen, um das Wachstum einer dickeren Schale zu fördern. Diese Wachstumskammer hat vorzugsweise die gleiche Temperatur wie die Reaktionszone. Grundsätzlich kann man die Schalendicke über die Konzentration der Ausgangsstoffe, über die Temperatur in der Reaktionszone (die unterhalb der Nukleationstemperatur für die Schalenausgangsstoffe liegen sollte), die Verweilzeit und/oder über die Menge an Stabilisator beeinflussen.

Im Anschluss an Schritt h) können die Kern/Schale-Nanopartikel auf herkömmliche Weise isoliert werden, beispielsweise durch Zentrifugieren oder durch Zugabe eines Lösungsmittels, in dem die Teilchen keine oder eine nur geringe Dispergierbarkeit zeigen. Bevorzugtermaßen erfolgt die Isolierung durch Zentrifugieren.

Gemäß der Erfindung enthält die in Schritt a) hergestellte Dispersion von Partikeln aus dem Kernmaterial mindestens einen Ausgangsstoff für das Kernmaterial, z.B. Cd und Se. So nutzt man vorteilhafterweise die hergestellte Kernpartikeldispersion, die noch nicht abreagierten Ausgangsstoffe für das Kernmaterial enthält, nach der Synthese ohne weitere Reinigungs- und
Aufbereitungsschritte. In der Reaktionszone bewirken die vorhandenen Ausgangsstoffe für das Kernmaterial, dass das Schalenmaterial nicht unmittelbar auf die Kerne aufwächst unter Ausbildung einer klaren Grenze zwischen Kern- und Schalenmaterialphase. Es bildet sich zwischen Kern und Schale eine Schicht aus einer Übergangszone **("Übergangsschicht")** aus, in welcher der Anteil des Kernmaterials allmählich in Richtung der Schale abnimmt und gleichzeitig der Anteil des Schalenmaterials allmählich zunimmt. Diese Übergangsschicht unterscheidet sich von der Übergangsschicht der WO 2003/092043 somit dadurch, dass sie sowohl aus Kernmaterial als auch aus Schalenmaterial mit gegenläufigen Gradienten aufgebaut ist, und außer den Metall- und Nichtmetallkomponenten des Kern- und des Schalenmaterials keine weiteren Bestandteile enthält. Die Übergangszone von CdSe/ZnS-Kern/Schale-NP besteht beispielsweise nur aus den Elementen Cd, Se, Zn und S.

Diese Übergangsschicht entsteht, solange noch ausreichend Ausgangsstoffe für das Kernmaterial zur Verfügung stehen. Die Konzentration der Ausgangsstoffe für das Kernmaterial nimmt entlang der Reaktionszone in Flussrichtung der Kerne ab, da keine neuen Ausgangsstoffe für das Kernmaterial zugeführt werden. Sobald nicht mehr genügend Kernausgangsstoffe für das Wachstum der Übergangsschicht zur Verfügung stehen, wird dann allein Schalenmaterial aufwachsen.

Vorzugsweise beträgt der mittlere Durchmesser der Kern/Schale-Nanopartikel von 1 bis 100 nm, vorzugsweise von 3 bis 15 nm, stärker bevorzugt von 4 bis 8 nm.

Bei Abweichung von der Kugelform versteht man unter "Durchmesser" die maximale Ausdehnung bei mikroskopischer Betrachtung. Eine Größenbestimmung erfolgt über TEM-Messungen wie sie in den Beispielen beschrieben sind (durch Auszählen von 100 Partikeln z.B. mit dem käuflich erhältlichen Programm "imageJ").

Die Teilchengrößenverteilung der Nanopartikel ist vorzugsweise derart, dass die Standardabweichung (in nm) vom Mittelwert des Durchmessers der Kern/Schale-Nanopartikel (in nm) weniger als 20%, vorzugsweise weniger als 15%, stärker bevorzugt weniger als 10%, noch stärker bevorzugt weniger als 7,5% des Mittelwerts beträgt. Selbst Werte von weniger als 5% des Mittelwerts lassen sich erfindungsgemäß erzielen, wie die Beispiele dieser Anmeldung zeigen.

Insbesondere bei CdSe/ZnS- oder CdSe/CdZnS-Nanopartikeln beträgt der mittlere Durchmesser des Kerns vorzugsweise von 2,6 bis 4,6 nm, stärker bevorzugt von 3,2 bis 3,8 nm und/oder der Durchmesser der Schale vorzugsweise von 0,2 bis 2,5 nm.

Der mittlere Durchmesser der Übergangsschicht beträgt von 0,1 bis 5 nm, vorzugsweise von 0,1 bis 2 nm, vorzugsweise von 0,3 bis 1,2 nm. Der Durchmesser lässt sich über den Konzentrationsverlauf der Bestandteile des Kern- und Schalenmaterials ermitteln. Konzentrationsverläufe in Nanopartikeln werden über TEM-Messungen nachgewiesen, wie wie sie von Z. Wang, Z. Li, A. Kornowski, X. Ma, A. Myalitsin, A. Mews, small 2011, 17, 2464-2468 beschrieben wurden.

Gemä einer Ausführungsform des erfindungsgemäßen Verfahrens sind das Kernmaterial und das Schalenmaterial jeweils ein II-VI- oder IV-VI-Halbleitermaterial, werden der oder die Ausgangsstoffe für die II- oder IV-Komponente des Halbleitermaterials in Schritt c) ausgewählt und in Schritt d) mit der Dispersion der Partikel aus dem Kernmaterial vermischt und wird der Ausgangsstoff für die VI-Komponente des Halbleitermaterials, bevorzugt ein Chalkogen wie S oder Se, in Schritt f) zugeführt. Grundsätzlich ist es jedoch auch möglich, umgekehrt zu verfahren und die Ausgangsstoffe für die VI-Komponente mit der Dispersion der Partikel aus dem Kernmaterial zu vermischen und die II- oder IV-Komponente in Schritt f) der Reaktionszone zuzuführen. Dies kann die Leuchteigenschaften positiv beeinflussen.

Gemäß der Erfindung ist die Reaktionszone des Röhrenreaktors von einer Membran umgeben. Somit führt man in Schritt e) die in Schritt d) erhaltene Mischung durch eine **röhrenförmige Membran,** welche die Reaktionszone des Röhrenreaktors bildet. Über die Membran werden in Schritt f) die nicht ausgewählten Ausgangsstoffe für das Schalenmaterial zugeführt. Diese Membran wird nachstehend anhand der Figuren und weiteren Beschreibung näher erläutert.

Diese Membran wird in ein vorzugsweise beheizbares Membranmodul eingepasst, das zusammen mit der Membran den Röhrenreaktor bildet.

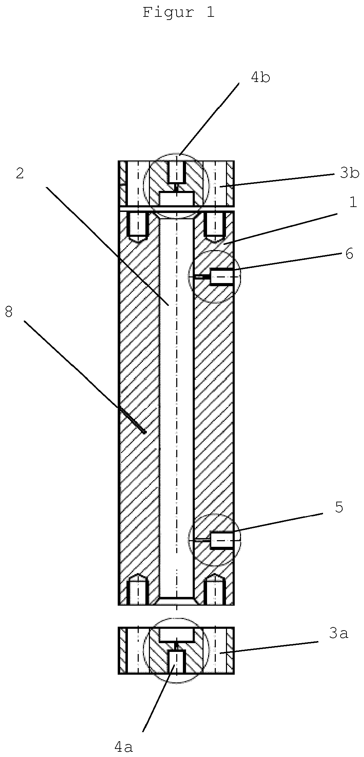

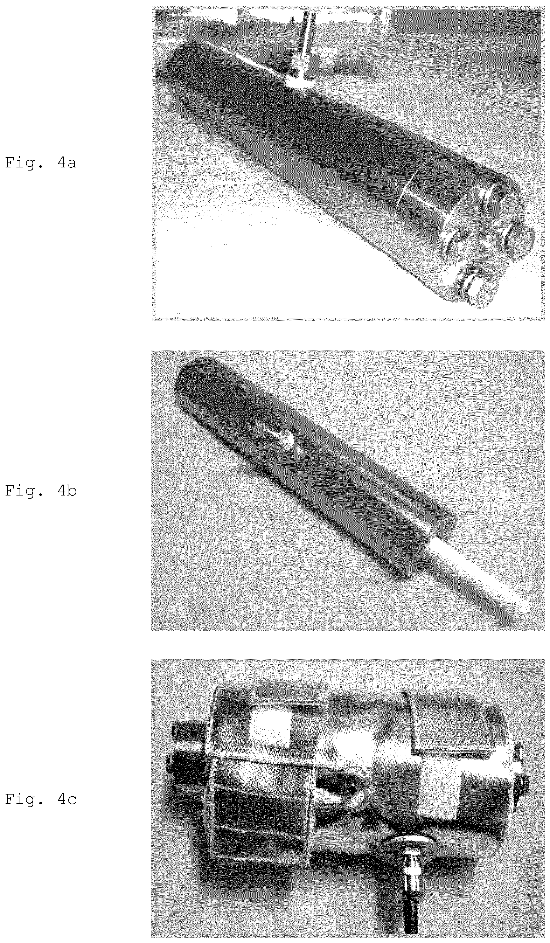

**Figur 1** erläutert eine mögliche Ausgestaltung dieses Röhrenreaktors (Membran hier nicht gezeigt). Der Röhrenreaktor (1) umfasst in Längsrichtung mindestens einen oder mehrere zylindrische Hohlräume (2) zur Aufnahme von einer oder mehreren röhrenförmigen Membranen (7), die in Figur 1 nicht gezeigt werden. Der Röhrenreaktor (1) weist an den gegenüberliegenden Enden zwei abnehmbare Verschlusselemente (Verschlusskappen) (3a) und (3b) auf. Diese Verschlusselemente können auf den zur Aufnahme der Membran(en) vorgesehenen Körper des Moduls aufgesetzt und beispielsweise wie in Figur 4a gezeigt mit vier Schrauben flüssigkeitsdicht befestigt werden. Beide Verschlusselemente (3a, 3b) weisen mindestens einen durchgehenden, zum Flüssigkeitstransport geeigneten Kanal (4a, 4b) auf, der mit einem zylinderförmigen Hohlraum (2) in Verbindung steht. Der Kanal kann mit einem Gewinde zur Befestigung von Zu- und Ableitungen ausgestattet sein. Einer der beiden Kanäle (4a) dient vorzugsweise dazu, die in Schritt d) des Verfahrens erhaltene Mischung aus Ausgangsstoff(en) für das
Schalenmaterial und Dispersion der Kernpartikel durch die Membran (Reaktionszone) im Röhrenreaktor zu führen, während der andere Kanal (4b) dann zur Ableitung der gebildeten Kern/Schale-Nanopartikel dient.

Die Fließgeschwindigkeit im Röhrenreaktor wird in Abhängigkeit vom inneren Durchmesser der Membran und im Hinblick auf eine angemessene Reaktionszeit gewählt und kann z.B. 0,5 bis 10 ml/min betragen. Die Verweilzeit im Röhrenreaktor kann z.B. 1 min bis 30 min betragen und ist die Zeit vom Eintritt der Nanokernpartikel, z.B.Cadmiumselenid-Nanokernpartikel in das Innere der Membran bis zum Austritt der Kern/Schale-Nanopartikel aus dem Röhrenreaktor. In der Wand des zylinderförmigen Röhrenreaktors (1) ist mindestens ein Zufluss (5) vorgesehen für das Zuführen von Ausgangsstoff(en) für das Schalenmaterial in Schritt f) zu der Reaktionszone in der Membran. Auch dieser Zufluss (Flüssigkeitskanal) ist vorzugsweise mit einem Gewinde zur Aufnahme von Leitungen versehen. Spezielle Beschränkungen hinsichtlich der Position des Zuflusses (5) gibt es nicht. Vorzugsweise befindet er sich innerhalb der ersten zwei Drittel (in Flussrichtung) der Länge der durch die Membran gebildeten Reaktionszone. In einer vorteilhaften Ausgestaltung, die in Figur 4a gezeigt wird, befindet sich der Zufluss (5) in der Mitte des Moduls (1) und damit auch in der Mitte der durch die Membran gebildeten Reaktionszone. Der Flüssigkeitskanal (6) ist optional und kann als Abfluss für Ausgangsstoff(e) des Schalenmaterials für eine weitere Schale genutzt werden. Der Flüssigkeitskanal (6) kann somit auch eine Kontrolle des lateralen Stroms zusätzlich zum Pumpendruck ermöglichen.

Zur Temperaturkontrolle kann man einen in Figur 1 (und Figur 3) gezeigten Temperaturfühler (8) in der Wand des zylinderförmigen Reaktors (1) vorsehen.

In Schritt f) erfolgt das Zuführen von Ausgangsstoff(en) für das Schalenmaterial über die Poren der Membran und damit über sehr viele Stellen zu der Reaktionszone im Inneren der Membran.

Röhrenreaktoren der zuvor beschriebenen Art kann man durch Weiterentwicklung und Umbau von käuflich erhältlichen Membranmodulen zur Abwasserreinigung herstellen. Als Ausgangspunkt für den Bau eines erfindungsgemäß geeignete Röhrenreaktoren können beispielsweise die von *atech innovations GmbH,* 45966 Gladbeck, Deutschland, angebotenen Membranmodule dienen, die zur Abwasserreinigung genutzt werden.

Diese aus Stahl hergestellten, käuflichen Module sind nicht für die Synthese von Nanopartikeln geeignet, so dass es erfindungsgemäß bevorzugt ist, den Röhrenreaktor aus einem auch bei höherer Temperatur chemisch inerten metallischen Material wie Titan herzustellen. Darüber hinaus ist, wie bereits erläutert, der bei den atech-Modulen in der Reaktorwand vorhandene zweite Flüssigkeitskanal (6) oft nicht erforderlich. Durch geeignete Zudosierung über einen einzigen Zufluss (5) kann man erreichen, dass der Ausgangsstoff bzw. die Ausgangsstoffe für das Schalenmaterial über die Membranwand vollständig von der Reaktionszone aufgenommen werden, so dass es keines Abflusses bedarf. Darüber hinaus ist es, im Unterschied zur Abwasserreinigung, in der Regel erforderlich, den Modul beheizbar auszugestalten, wie dies nachstehend in Verbindung mit Figur 4c erläutert wird.

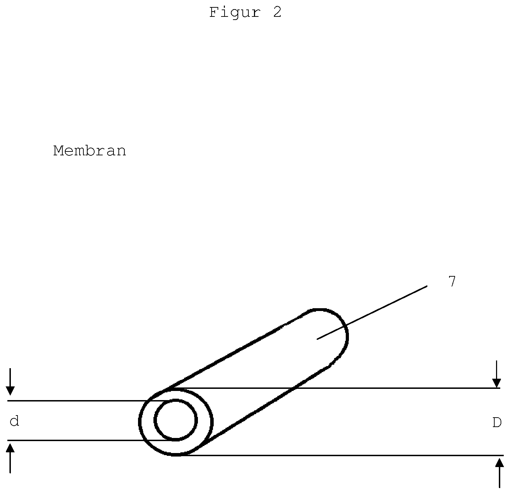

**Figur 2** zeigt eine erfindungsgemäß geeignete Membran (7) mit einem äußeren Durchmesser D und einem inneren Durchmesser d. Der innere Durchmesser der verwendeten Membran(en) beträgt vorzugsweise 0,2 - 5 cm, stärker bevorzugt 0,4 bis 1 cm. Die Membran wird beim Zuführen des bzw. der Ausgangsstoffe für das Schalenmaterial in Schritt f) von diesen umspült. Der bzw. die Ausgangsstoffe dringen durch die Poren zu der
Reaktionszone im Inneren der Membran vor, wo sie erstmals in Kontakt mit dem Ausgangsstoff bzw. den Ausgangsstoffen für das Schalenmaterial in Kontakt kommen, die mit der Dispersion der Kernpartikel in Schritt d) vermischt wurden. Die Ausgangsstoffe reagieren miteinander unter Bildung einer Schale auf den Kernpartikeln, ggf. nach Bildung der - Übergangsschicht.

Die röhrenförmige Membran (7) besteht vorzugsweise aus einem keramischen Material, wie Al₂O₃ oder TiO₂. Die Porengröße der Membran wird in Abhängigkeit von der Größe der verwendeten Kernpartikel gewählt. Bei der im Allgemeinen bevorzugten Synthese von Kern/Schale-Nanopartikeln mit einem mittleren Gesamtdurchmesser von weniger als 20 nm, insbesondere bis zu 15 nm kann man vorteilhafterweise mit Membranen arbeiten, deren Porendurchmesser einem MWCO (molecular weight cut off) für ein hypothetisches globuläres Protein (bei 90%iger Rückhaltung), von z.B. 200 Dalton oder weniger, z.B. 100 Dalton oder weniger, z.B. 80 Dalton oder weniger, z.B. 50 Dalton oder weniger, oder 20 Dalton oder weniger entspricht. Abgesehen von dem Porendurchmesser der Membran kann man auch über den Pumpendruck am Zufluss (5) regulieren, dass der Durchtritt von Kernpartikeln durch die Membran minimiert oder verhindert wird.

**Figur 3** zeigt einen Querschnitt durch den Röhrenreaktor (1) mit darin eingepasster Membran (7) auf der Höhe des Zuflusses (5). Die Membran ist in dem Hohlraum (2) des Röhrenreaktors (1) längs (entlang der Flussrichtung) angeordnet. Die Membran unterteilt den Hohlraum (2) (siehe Figur 1) in eine Zudosierzone (9) und eine Reaktionszone (10).

Man erkennt, dass der Durchmesser des zylinderförmigen Hohlraums (2) größer gewählt werden sollte, als der äußere Durchmesser der Membran, damit diese in der Zudosierzone (9) von Ausgangsstoff(en) für das Schalenmaterial umspült werden kann, die über den Zufluss (5) zugeführt werden.

**Figur 4a** zeigt eine vorteilhafte Ausgestaltung des Röhrenreaktors mit nur einem Zufluss (5). **Figur 4b** zeigt den Röhrenreaktor (1) nach Entfernen eines der abnehmbaren Verschlusselemente (3a, 3b) mit herausgezogener Membran (7). **Figur 4c** zeigt eine für den Röhrenreaktor (1) entwickelte Heizmanschette, welche den Metallmantel möglichst passgenau umschließt. Erfindungsgemäß ist es jedoch auch möglich, die Reaktionszone des Röhrenreaktors auf andere Weise zu erhitzen, z.B. durch Eintauchen in ein Heizbad oder durch Einbau von Heizelementen in den Röhrenreaktor.

Ein Gegenstand der Erfindung ist auch die bereits erläuterte Ausführungsform der Kern/Schale-Nanopartikel, die durch eine Übergangsschicht zwischen Kern und Schale gekennzeichnet ist, welche Gitterspannungen zwischen Kern- und Schalenmaterial ausgleicht und somit auch zu erhöhten Quantenausbeuten beiträgt.

Diese Ausführungsform betrifft Kern/Schale-Nanopartikel, die einen Kern aus einem Kernmaterial, vorzugsweise einem ersten Halbleitermaterial, und eine äußere Schale aus einem Schalenmaterial umfassen, vorzugsweise aus einem zweiten Halbleitermaterial, dadurch gekennzeichnet, dass sich zwischen Kern und Schale nur eine Schicht aus einer Übergangszone befindet, in welcher der Anteil des Kernmaterials allmählich in Richtung der Schale abnimmt und gleichzeitig der Anteil des Schalenmaterials allmählich zunimmt.

Es ist bevorzugt, dass in den erfindungsgemäßen Kern/Schale-Nanopartikel der Kern aus einem Licht-emittierenden Halbleitermaterial besteht und die Teilchengrößenverteilung der Nanopartikel derart ist, dass die Teilchen bei Bestrahlung Licht in einer spektralen Halbwertsbreite (FWHM) von weniger als 40 nm, z. B. nicht mehr als 35 nm, vorzugsweise nicht mehr als 30 nm emittieren.

Die Teilchengrößenverteilung der Nanopartikel ist vorzugsweise derart, dass die Standardabweichung (in nm) vom Mittelwert des Durchmessers der Kern/Schale-Nanopartikel (in nm) weniger als 20%, vorzugsweise weniger als 15%, stärker bevorzugt weniger als 10%, noch stärker bevorzugt weniger als 6,5% des Mittelwerts beträgt.

Die obige Beschreibung der im erfindungsgemäßen Verfahren hergestellten Kern/Schale-Nanopartikel ist im vollen Umfang auf die beanspruchte Ausführungsform mit Übergangszone übertragbar.

So gilt beispielsweise auch, dass der mittlere Durchmesser der Übergangszone von 0,1 bis 5 nm, vorzugsweise von 0,3 bis 1,2 nm beträgt, und vorzugsweise der mittlere Durchmesser der Kern/Schale-Nanopartikel von 1 bis 100 nm, vorzugsweise von 3 bis 15 nm, stärker bevorzugt von 4 bis 8 nm beträgt.

Vorzugsweise sind das Kernmaterial und das Schalenmaterial jeweils ein Halbleitermaterial, vorzugsweise jeweils ein II-VI-, III-V- oder IV-VI-Halbleitermaterial.

Besonders bevorzugt sind Kern/Schale-Nanopartikel, worin die Kern/Schale-Nanopartikel eine Kombination der folgenden Kern/Schalenmaterialien aufweisen: CdSe/ZnS, CdSe/CdZnS, CdSe/CdZnSe.

In einer weiteren Ausführungsform werden auch Kern/Schale-Nanopartikel beansprucht, worin die Kern/Schale-Nanopartikel durch ein Verfahren erhältlich sind, wie es zuvor und in den Ansprüchen definiert ist.

Die zuvor und in den Ansprüchen beschrieben Ausgestaltung des Röhrenreaktors ermöglicht es, das erfindungsgemäße Verfahren auf besonders einfache, dabei aber effiziente und somit kostengünstige Weise umzusetzen.

Die Membran des Röhrenreaktors besteht vorzugsweise aus einem keramischen Material wie Al₂O₃ oder TiO₂ und deren Porengröße wird so gewählt, dass sie einen Durchtritt der Kernpartikel in die umgebende Zudosierzone verhindert.

Aufgrund der über die gesamte Länge des Röhrenreaktors ablaufenden Reaktion hat es sich dabei als vorteilhaft herausgestellt, dass bei dem erfindungsgemäß verwendeten Röhrenreaktor in der Wandung genau ein Anschluss (5) für die Zugabe weiteren Ausgangsmaterials für die Schale vorgesehen ist, welcher z.B. in Längsrichtung des Reaktors mittig, aber auch an einer anderen Position in den ersten zwei Dritteln (in Längs- und Flussrichtung) des Reaktors angeordnet sein kann. Dadurch kann das zudosierte Schalenausgangsmaterial vollständig zur schalenbildenden Reaktion beitragen, was ein wiederholtes Rückführen oder Entsorgen unverbrauchten Materials vermeidet und somit eine kürzere Synthesezeit ermöglicht. Da keine Ableitung für unverbrauchtes Schalenausgangsmaterial vorgesehen werden muss, werden auch der Aufbau des Reaktors vereinfacht und somit seine Beschaffungskosten verringert. Der eine Anschluss erlaubt eine gleichmäßige Verteilung des zuzugebenden Schalenausgangsmaterials in der Zudosierzone und somit eine zunehmende Konzentration des Schalenausgangsmaterials in der Reaktionszone (dort wird es in Flussrichtung mit der reagierenden Mischung mitgeführt und reichert sich somit in Flussrichtung an).

In einer hierzu alternativen Ausführungsform des erfindungsgemäß verwendeten Röhrenreaktors ist in der Wandung ein weiterer Anschluss entweder für die Zuführung von weiterem Ausgangsmaterial zur Schalenbildung oder zur Abfuhr von Ausgangsmaterial zur Schalenbildung vorgesehen. Auf diese Weise kann die Konzentration des Schalenausgangsmaterials entlang der Zudosierzone und z.B. die Zunahme der Konzentration des Schalenausgangmaterials entlang der Reaktionszone gesteuert werden oder der laterale Fluss genauer eingestellt werden. Sollte es gewünscht sein, kann der weitere Anschluss aber auch für die Abführung überschüssigen Ausgangsmaterials für die Schale verwendet werden.

Besonders bevorzugt bestehen die Wandung des Röhrenreaktors, sowie eventuell weitere Komponenten, wie die Verschlusselemente, aus Titan. Durch diese Materialwahl kann eine inerte Reaktionsumgebung bereitgestellt werden, die auch bei den für die Ausbildung der erfindungsgemäßen Nanopartikel erforderlichen hohen Temperaturen und in Gegenwart chemisch aggressiver Ausgangsstoffe nicht angegriffen wird.

Es ist von besonderem Vorteil, dass gemäß einer weiteren Ausführungsform der Verwendung des Röhrenreaktors die Membran röhrenförmig ist und im Inneren die Reaktionszone ausbildet. Auf diese Weise wird eine besonders große, sich entlang des Hohlraums erstreckende Oberfläche für den Zustrom von Schalenausgangsmaterial (oder anderen zuzugebenden Substanzen) von der Zudosierzone durch die Membran in die Reaktionszone bereitgestellt, mit dementsprechend vielfach erhöhter Reaktionseffizienz.

Gemäß einer weiteren bevorzugten Ausführungsform wird der Reaktor an beiden Enden jeweils von einem abnehmbaren Verschlusselement, in welchem die Zu- bzw. Ableitung eingelassen sind, flüssigkeitsdicht abgeschlossen. Die Verschlusselemente werden dabei an die offenen Enden des röhrenförmigen, die Membran umfassenden Hohlraums angeschlossen. So kann ein modularer Röhrenreaktor bereitgestellt werden, dessen an den Enden vorgesehenen abnehmbaren Verschlusselemente Zugang zum Inneren des Reaktors ermöglichen, beispielsweise zum Einbringen der Membran. Auch können je nach Art der durchgeführten Synthesereaktion Verschlusselemente mit mehreren Zu- bzw. Ableitungen vorgesehen werden, oder weitere Reaktoren angeschlossen werden.

Schließlich ist es besonders vorteilhaft, dass der Röhrenreaktor eine bevorzugt manschettenförmige Heizvorrichtung zur Beheizung der Reaktionszone umfasst. Durch Beheizung der Reaktionszone kann die Synthesereaktion wesentlich rascher ablaufen. Außerdem kann durch Wahl einer geeigneten Temperatur auch das Reaktionsergebnis, also die Güte bzw. Struktur der erzeugten Kern/Schale-Nanopartikel beeinflusst werden.

### Beispiele

### Messverfahren

### Mittlerer Durchmesser (TEM)

Der mittlere Durchmesser wurde durch Messung von 100 Partikeln im TEM-Bild bestimmt. Es wurde das Programm imageJ 1.40g Wayne Rasband, National Institutes of Health, USA, Java 1.6.0_05, 1720 K of 594 MB (<1%) verwendet. Nach Kalibrierung der Pixelgrößen mit Hilfe der Längenskala im TEM-Bild konnten die Flächen der Partikel durch manuelle Einzeichnung eines einhüllenden Kreises bestimmt werden. Aus der Fläche der einzelnen Partikel konnten die Durchmesser berechnet werden.

### Quantenausbeute

Die Quantenausbeute wurde durch Referenzmessung gegen Rhodamin 6G bestimmt. Hierzu wird die Absorption der zu bestimmenden Probe mit der Absorption des dispergierten Farbstoffes gemessen. Anschließend wird je eine Emissionsmessung durchgeführt. Als Anregungswellenlänge wird die Wellenlänge verwendet, bei der beide Proben eine identische optische Dichte besitzen. Die Quantenausbeute ergibt sich aus dem Verhältnis beider Flächen unter der Emissionskurve multipliziert mit der Quantenausbeute des Referenzfarbstoffes (hier 0.96).

### FWHM

Der FWHM-Wert (Halbwertsbreite) wird über die Emissionsbande ermittelt. Es handelt sich hierbei um die volle Signalbreite auf halber Signalhöhe. Es gilt je geringer dieser Wert desto enger die Größenverteilung.

### Bezugsbeispiel 1 - CdSe-Kern Nanopartikel

### Darstellung der Cadmium-Stammlösung

Die Beschreibung der Synthese erfolgt unter Bezugnahme auf die Figuren 1a, 1b und 1c der WO 2009/101091.

1.15 g Cadmiumacetat wurden zu 45 mL Squalen, 3.5 mL Ölsäure und 20 mL Oleylamin bei Raumtemperatur gegeben. Das Gemisch wurde unter vermindertem Druck entgast, mit Stickstoff gespült und auf 150 °C erhitzt. Es entstand eine trübe gelbe Lösung. Diese wurde für 2 h bei 100 °C unter vermindertem Druck entgast. Die nun hellgelbe klare Lösung wurde unter Stickstoffatmosphäre bei Raumtemperatur gelagert.

Darstellung der Selen-Stammlösung. In einer Glovebox wurden bei Raumtemperatur 2,0 g Selen in 17 mL Trioctylphosphin gelöst. Zu dieser Lösung wurden 53 mL Squalen hinzugefügt. Diese Lösung wurde unter inerten Bedingungen bei Raumtemperatur gelagert.

Darstellung der CdSe Core Nanopartikel. Die Cadmiumlösung und die Selenlösung wurden über 2 Pumpen verbunden und in das Modul 15 (siehe Fig. 1a der WO 2009/101091) geleitet. Die Nukleationskammer 60PSM (siehe Fig. 1b der WO 2009/101091) wurde auf die Nukleationstemperatur (ca. 250 °C) geheizt. Der Wachstumsofen 65PSM war auf die Wachstumstemperatur (ca. 240 °C) und die beiden Vorheizöfen 55PSMa und 55PSMb wurden auf die Nukleationstemperatur (ca. 250 °C) eingestellt. Die Fließgeschwindigkeiten wurden in Hinblick auf eine angemessene Reaktionszeit in Apparatur 20 gewählt. Als Verweilzeit definiert man die Zeit, die für das Durchfließen der Nukleationskammer 60PSM und des Wachstumsofens 65PSM benötigt wird. Die optischen Eigenschaften der hergestellten Nanopartikel wurden nach Erreichen der doppelten Verweilzeit gemessen. Die einstellbaren Syntheseparameter sind zum einen die Flussrate und zum anderen die Temperatur. Die besten Syntheseparameter für die Herstellung von CdSe-Kern-Nanopartikel wurden aus vorangegangenen Experimenten bestimmt.

Der mittlere Partikeldurchmesser der so hergestellten Kerne wurde über TEM-Messungen auf ca. 3,4 nm bestimmt. Die Quantenausbeute lag bei ca. 40 %.

### Beispiel 1 - CdSe/CdZnS - Kern/Schale - Nanopartikel

Darstellung der Zink-Stammlösung. 466 mg Zinkacetat wurden in 12 mL Squalen und 4.0 mL Trioctylphosphin bei 200 °C gelöst. Die Lösung war klar und farblos. Diese Lösung wurde unter inerten Bedingungen bei Raumtemperatur aufbewahrt und kann als Alloyprecursor (Ausgangsstoff für Schale) verwendet werden.

Darstellung der Cadmium-Stammlösung. 533 mg Cadmiumacetat wurden in 11 mL Squalen, 1,6 mL Ölsäure und 4,0 mL Oleylamin bei 130 °C gelöst. Die hellgelbe klare Lösung wurde anschließend für 4 h bei 110 °C unter vermindertem Druck entgast. Diese Lösung wurde unter inerten Bedingungen bei Raumtemperatur aufbewahrt und kann als Alloyprecursor verwendet werden.

Darstellung der Schwefel-Stammlösung. In der Glovebox wurden 0,8 mL Bis(trimethylsilyl)sulfid mit 11 mL Trioctylphosphin bei Raumtemperatur vermischt. Die Lösung war klar und leicht gelblich. Diese Lösung wurde unter inerten Bedingungen bei Raumtemperatur aufbewahrt und kann als Alloyprecursor verwendet werden.

Die CdSe-Nanopartikel wurden wie in Bezugsbeispiel 1 bereits beschrieben hergestellt. Die so hergestellte Dispersion (ca. 1 Gew.%) enthielt noch Anteile (ca. 0,2 mol/l) des Ausgangsmaterials für den Selenbestandteil und noch geringe Mengen des Ausgangsmaterials für den Cadmiumbestandteil der CdSe-Kerne.

Darstellung der CdSe/CdZnS-Kern/Schale-Nanopartikel. Ein Röhrenreaktor aus Titan, wie er in den Figuren 1 bis 4 erläutert wird, jedoch mit nur einem Zufluss (Fig. 4a), wurde mit einer Al₂O₃-Membran (Typ 1/6, Länge 20 bzw. 50 cm, 20k oder 100k Dalton) versehen, die bei *atech innovations GmbH,* 45966 Gladbeck, Deutschland) erworben werden kann. Die Membran hatte einen Kanal mit einem inneren Durchmesser von 6mm und einem äußeren Durchmesser von 10mm. Der innere Durchmesser des Röhrenreaktors (Moduls) betrug 11,2 mm. Der Röhrenreaktor wurde über eine Heizmanschette, wie sie in Figur 4c gezeigt wird, auf eine Temperatur von ca. 110°C erhitzt. Der Röhrenreaktor dient als Wachstumsofen für die Alloy-Schale und ersetzt in Figur 1c der WO 2009/101091 die obere Heizkammer 55SSM. Die CdSe-Kern-Nanopartikel wurden vor Eintritt ins Innere der Membran mit dem Zink- und dem Cadmiumprecursor bei Raumtemperatur in einer Mischkammer vermischt, welche in Fig. 1c die Nukleationskammer 60SSM ersetzt, und von Pumpen über die Leitungen 35h und 35ca der Mischkammer ("Mk2") zugeführt. Mittels Solvent-Organizer wurde ein Pump-Verhältnis von Zn/Cd 40% zu 60% eingestellt.

Der Schwefelprecursor wurde von einer weiteren Pumpe über den Zufluss des Röhrenreaktors (siehe Figur 4a) außen an die Membran geleitet und diffundierte durch die Membran in den Innenraum des Röhrenreaktors, in dem das Schalenwachstum stattfindet. Durch die getrennte Zugabe der Ausgangsmaterialien (Precursor) wird die ungewollte Bildung von CdS- oder ZnS- Kern-Nanopartikeln verhindert. Durch die Zugabe über eine längliche Rohrmembran wird ein Konzentrationsgradient bewirkt, der ein epitaxiales Aufwachsen der Alloy-Schale begünstigt.

Zur Verlängerung der Wachstumszeit wurden die CdSe-CdZnS Kern/Schale-Nanopartikel nach Austritt aus dem Modul in einen weiteren Wachstumsofen geleitet. Dieser wurde auf die gleiche Temperatur wie der Membranofen 65PSM geheizt. Die Verweilzeit im Röhrenreaktor ist die Zeit vom Eintritt der Cadmiumselenid-Nanokernpartikel in das Innere der Membran bis zum Austritt der Kern/Schale-Nanopartikel aus diesem Wachstumsofen. Sie beträgt ca. 8 min bei Verwendung der 20 cm langen Membran und ca. 16 min bei Verwendung der 50 cm langen Membran.

Die optischen Eigenschaften der hergestellten Nanopartikel wurden nach Erreichen der doppelten Verweilzeit gemessen. Die einstellbaren Syntheseparameter sind zum einen die Flussraten und zum anderen die Temperatur. Die besten Syntheseparameter für die Herstellung von CdSe-CdZnS Core-Alloy Nanopartikel wurden aus vorangegangenen Experimenten bestimmt und sind in der folgenden Tabelle 1 zusammengefasst.

Mk2(°C) gibt die Temperatur der Mischkammer an und VO(°C) die Temperatur des Wachstumsofens, der dem Röhrenreaktor mit Membran nachgeschaltet ist.

**Tabelle 1**

| **CdSe/CdₓZn₍₁₋ₓ₎ S-Kern/Schale-Nanopartikel** | | | | | | | | |
|---|---|---|---|---|---|---|---|---|
| **Probe** | v **(Zn+Cd) [mL/min]** | **v(S) [mL/min]** | **Heizmanschette [°C]** | **Mk2 [°C]** | **VO [°C]** | **Emission** | **FWHM** | **QA (Stamm)** |
| M7_B_ 90 | 0,4 | 0,6 | 90 | 90 | 120 | 591 | 28 | 75 |
| M7_B_100 | 0,4 | 0,6 | 100 | 100 | 120 | 593 | 29 | 75 |
| M7_B_110 | 0,4 | 0,6 | 110 | 110 | 120 | 590 | 30 | 80 |
| M7_B_120 | 0,4 | 0,6 | 120 | 120 | 120 | 590 | 32 | 75 |

Nach der Synthese der CdSe/CdZnS Kern/Schale-Nanopartikel wurde das Modul mit reinem Lösungsmittel gespült und auf Raumtemperatur abgekühlt.

Der mittlere Partikeldurchmesser der so hergestellten Kern-Schale-NPs wurde über TEM-Messungen auf 4,3 bis 4,6 nm bei den in der folgenden Tabelle 2 angegebenen Standardabweichungen bestimmt. Die Quantenausbeute betrug 60-70 %.

**Tabelle 2**

| **CdSe/CdₓZn_{(1-X)}S -Kern/Schale-Nanopartikel** | | | |
|---|---|---|---|
| **Reaktionstemperatur der Schale** | **Durchmesser der Kern/Schale NP** | **Standardabweichung** | **Anzahl an Monolagen** |
| 90 | 4, 6 | 0,23 | 1, 9 |
| 100 | 4, 6 | 0,25 | 1, 9 |
| 110 | 4,3 | 0,27 | 1,3 |
| 120 | 4,5 | 0,28 | 1,7 |

Wiederholt man die Partikelsynthese gemäß Beispiel 1 stellt man nur sehr geringe Abweichungen in der Produktqualität fest. So beträgt z.B. die Abweichung des Emissionsmaximums in der Regel deutlich weniger als 1%.

### Beispiel 2 - CdSe/ZnS - Kern/Schale - Nanopartikel

Die CdSe Nanopartikel wurden wie in Bezugsbeispiel 1 bereits beschrieben hergestellt. Die so hergestellte Dispersion (ca. 1 Gew.%) enthielt noch Anteile (ca. 0,2 mol/l) des Ausgangsmaterial für den Selenbestandteil und noch geringe Mengen der des Ausgangsmaterial für den Cadmiumbestandteil der CdSe-Kerne.

Die Darstellung der Zink-Stammlösung und der Schwefel-Stammlösung erfolgte wie in Beispiel 1.

Die Darstellung der CdSe/ZnS Kern/Schale-Nanopartikel erfolgte mit dem in Beispiel 1 beschriebenen Röhrenreaktor und Versuchsaufbau in verschiedenen Versuchsreihen:
"Atech8 Reihe A" und "Reihe B" unterschieden sich in der Zugabe der Schalenausgangsstoffe (Precursor).
- In Reihe A werden die CdSe Kerne vorher mit der Schwefelprecursor-Lösung in einer Mischkammer ("Mk2") vermischt, bevor sie ins Innere des Röhrenreaktors geführt wurden. Die Zinkprecursor-lösung wird über den Zufluss (5) von außen an die Membran geleitet, strömt durch die Membran in den Innenraum der röhrenförmigen Membran, in welcher das Schalenwachstum stattfindet.
- In Reihe B werden die beiden Precursor-Lösungen im Vergleich zu Reihe A umgekehrt hineingeleitet.

Die Versuchsreihen "M8_B" und "M8_C" unterschieden sich im Zink/Schwefel-Verhältnis, das über die Flussgeschwindigkeiten der Precursor-Lösungen (v(Zn) bzw. v(S)) eingestellt wurde:
- In den Versuchsreihen M8_B beträgt das molare Verhältnis zwischen Zink und Schwefel 1 : 2.6,
- in den Versuchsreihen M8_C hingegen 1 : 4.5.

Die folgenden Tabellen 3 und 4 fassen die Ergebnisse der Versuchsreihen zusammen. Mk2(°C) gibt die Temperatur der Mischkammer an und VO(°C) die Temperatur der nachgeschalteten Wachstumskammer. Die so erhaltenen CdSe/ZnSe-Kern/Schale-Nanopartikel wurden hinsichtlich ihrer Quantenausbeute (QA) und Teilchengrößenverteilung bewertet. Da die Emissionswellenlänge bei Halbleiter-NPs vom Partikeldurchmesser abhängt, ist der FWHM (full width at half maximum) ein Maß für die Breite der Partikelgrößenverteilung. Je kleiner der Wert, desto enger ist die Teilchengrößenverteilung.

Die Zuleitung des S-Precursors über die Membran von außen führte zu Teilchen mit einer gleichförmigeren sphärischen Form (Reihe B). Bei umgekehrter Zuleitung von Zn- und S-Precursor (Reihe A) erhält man jedoch höhere Quantenausbeuten.

Zum Vergleich wurde die Emissionswellenlänge (580nm) der in Bezugsbeispiel 1 hergestellten CdSe-Kerne und ihr FWHM Wert (ca. 28nm) bestimmt. Die Quantenausbeute der CdSe-Kerne lag bei ca. 40 %.

An dem Vergleich mit den FWHM-Werten für die CdSe-Kerne erkennt man, dass das Aufwachsen des ZnS-Schalenmaterials nur zu einer geringfügigen Verbreiterung der Teilchengrößenverteilung führt. Gleichzeitig stellt man für die bei diesem System bevorzugten Reaktionstemperaturen von mindestens 90 °C, insbesondere mindestens 100 °C, eine signifikante Verbesserung der Quantenausbeute fest.

Wiederholt man die Partikelsynthese gemäß Beispiel 2 stellt man nur sehr geringe Abweichungen in der Produktqualität fest. So beträgt z.B. die Abweichung des Emissionsmaximums in der Regel deutlich weniger als 1%.

**Tabelle 3**

| **Atech 8 Reihe A CdSe/ZnS-Kern/Schale-Nanopartikel** | | | | | | | | |
|---|---|---|---|---|---|---|---|---|
| **Probe** | **v(Zn) [mL/min]** | **v(S) [mL/min]** | **Heizmanschette [°C]** | **Mk2 [°C]** | **VO [°C]** | **Emission** | **FWHM** | **QA (Stamm)** |
| M8_B_80_ReiheA | 0,3 | 0,55 | 80 | 80 | 80 | 584 | 32 | 42 |
| M8_B_90_ReiheA | 0,3 | 0,55 | 90 | 90 | 90 | 583 | 30 | 56 |
| M8_B_100_ReiheA | 0,3 | 0,55 | 100 | 100 | 100 | 585 | 30 | 58 |
| M8_B_110_ReiheA | 0,3 | 0,55 | 110 | 110 | 110 | 585 | 29 | 60 |
| M8_B_120_ ReiheA | 0,3 | 0,55 | 120 | 120 | 120 | 584 | 30 | 61 |
| | | | | | | | | |
| M8_C_80_ReiheA | 0,25 | 0,8 | 80 | 80 | 80 | 585 | 31 | 40 |
| M8_C_90_ReiheA | 0,25 | 0,8 | 90 | 90 | 90 | 583 | 31 | 55 |
| M8_C_100_ReiheA | 0,25 | 0,8 | 100 | 100 | 100 | 583 | 30 | 47 |
| M8_C_110_ReiheA | 0,25 | 0,8 | 110 | 110 | 110 | 586 | 30 | 50 |
| M8_C_120_ReiheA | 0,25 | 0,8 | 120 | 120 | 120 | 585 | 30 | 63 |

**Tabelle 4**

| **Atech 8 Reihe B CdSe/ZnS-Kern/Schale-Nanopartikel** | | | | | | | | |
|---|---|---|---|---|---|---|---|---|
| **Probe** | **v(Zn) [mL/min]** | **v(S) [mL/min]** | **Heizmanschette [°C]** | **Mk2 [°C]** | **VO [°C]** | **Emission** | **FWHM** | **QA (Stamm)** |
| M8_B_80_ReiheB | 0,3 | 0,55 | 80 | 80 | 80 | 579 | 29 | 38 |
| M8_B_90_ReiheB | 0,3 | 0,55 | 90 | 90 | 90 | 582 | 29 | 52 |
| M8_B_100_ReiheB | 0,3 | 0,55 | 100 | 100 | 100 | 583 | 29 | 56 |
| M8_B_110_ReiheB | 0,3 | 0,55 | 110 | 110 | 110 | 585 | 31 | 44 |
| M8_B_120_ ReiheB | 0,3 | 0,55 | 120 | 120 | 120 | 586 | 32 | 48 |
| | | | | | | | | |
| M8_C_80_ReiheB | 0,25 | 0,8 | 80 | 80 | 80 | 585 | 31 | 43 |
| M8_C_90_ReiheB | 0,25 | 0,8 | 90 | 90 | 90 | 584 | 30 | 37 |
| M8_C_100_ReiheB | 0,25 | 0,8 | 100 | 100 | 100 | 582 | 30 | 50 |
| M8_C_110_ReiheB | 0,25 | 0,8 | 110 | 110 | 110 | 584 | 30 | 40 |
| M8_C_120_ReiheB | 0,25 | 0,8 | 120 | 120 | 120 | 585 | 32 | 43 |

### Durchmesser mit Standardabweichung:

Für die Bestimmung des Durchmessers der gemäß Tabelle 3 und 4 erhaltenen CdSe/ZnS-Kern/Schale-NP wurden 100 Nanopartikel (TEM-Aufnahmen) mit dem Programm imageJ ausgezählt und aus diesen Daten die Standardabweichung vom Mittelwert berechnet. Die Ergebnisse sind in den beiden folgenden Tabellen 5 und 6 zusammengefasst.

Die Ergebnisse der Tabelle 5 beziehen sich auf CdSe/ZnS-Kern/Schale-NP, deren Schale mit den in Tabelle 3 (Atech 8 Reihe A) aufgelisteten Einstellungen von M8_B_90_ReiheA bis M8_B_120_Reihe A synthetisiert wurden.

Die Ergebnisse der Tabelle 6 beziehen sich auf CdSe/ZnS-Kern/Schale-NP, deren Schale mit den in Tabelle 4 (Atech 8 Reihe B) aufgelisteten Einstellungen von M8_B_90_ReiheB bis M8_B_120_Reihe B synthetisiert wurden.

**Tabelle 5: CdSe/ZnS-Kern/Schale-NP**

| Reaktionstemperatur der Schale | Durchmesser der Kern/Schale NP | Standardabweichung | Anzahl an Monolagen |
|---|---|---|---|
| 90 | 3,8 | 0,19 | 0,5 |
| 100 | 4,0 | 0,16 | 0,7 |
| 110 | 4,0 | 0,20 | 0,8 |
| 120 | 3,8 | 0,27 | 0,7 |

**Tabelle 6: CdSe/ZnS-Kern/Schale-NP**

| Reaktionstemperatur der Schale | Durchmesser der Kern/Schale NP | Standardabweichung | Anzahl an Monolagen |
|---|---|---|---|
| 90 | 3,9 | 0,19 | 0,5 |
| 100 | 4,0 | 0,21 | 0,7 |
| 110 | 3,9 | 0,21 | 0,8 |
| 120 | 4,0 | 0,23 | 0,7 |

Man erkennt, dass die Standardabweichung (in nm) vom Mittelwert des Durchmessers der Kern/Schale-Nanopartikel (in nm) nicht mehr als ca. 7% des Mittelwerts beträgt, was einer sehr engen Teilchengrößenverteilung entspricht.

### Vergleichsbeispiel

CdSe/ZnS-Kern/Schale-Nanopartikel wurden nicht nach dem erfindungsgemäßen Verfahren mit einem Röhrenreaktor hergestellt, sondern gemäß der Lehre der WO 2009/101091 mit einem kontinuierlichen Flussreaktor, analog zu dem Beispiel 4 dieser Anmeldung bei einer Temperatur der Nukleationskammer 60 SSM und Wachstumskammer 65 SSM von 90 °C. Die Emissionswellenlänge der so erhaltenen CdSe/ZnS-Kern/Schale-Nanopartikel lag bei 583 nm, der FWHM bei 33 nm und die Quantenausbeute bei ca. 34 %.

## Patentansprüche

1. Verfahren zur kontinuierlichen Herstellung von Kern/Schale-Nanopartikeln, die einen Kern aus einem Kernmaterial, vorzugsweise aus einem Halbleitermaterial, und eine Schale aus einem Schalenmaterial, vorzugsweise aus einem Halbleitermaterial, umfassen,
wobei das Verfahren die folgenden Schritte umfasst:
a) das Herstellen einer Dispersion von Nanopartikeln aus dem Kernmaterial in einem Lösungsmittel,
b) das Bereitstellen aller Ausgangsstoffe für das Schalenmaterial, vorzugsweise in gelöster Form,
c) die Auswahl von einem oder mehreren Ausgangsstoffen für das Schalenmaterial für den Schritt d), wobei die Auswahl so erfolgt, dass die ausgewählten Ausgangsstoffe nicht untereinander reagieren,
d) das Vermischen des ausgewählten Ausgangsstoffs oder der ausgewählten Ausgangsstoffe für das Schalenmaterial mit der Dispersion der Nanopartikel aus dem Kernmaterial,
e) das kontinuierliche Führen der in Schritt d) erhaltenen Mischung durch eine Reaktionszone (10) eines Röhrenreaktors,
f) das kontinuierliche Zuführen des in Schritt c) nicht ausgewählten Ausgangsstoffes oder der in Schritt c) nicht ausgewählten Ausgangsstoffe für das Schalenmaterial an zwei oder mehr Stellen zu der Reaktionszone (10),
g) das Reagieren der Ausgangsstoffe für das Schalenmaterial in der Reaktionszone (10) unter Bildung einer Schale um die Nanopartikel aus dem Kernmaterial,
und wobei die Reaktionszone (10) des Röhrenreaktors von einer Membran (7) umgeben wird, über die in Schritt f) die in Schritt c) nicht ausgewählten ein oder mehrere Ausgangsstoffe für das Schalenmaterial zugeführt werden, worin die Kern-Schale-Nanopartikel zwischen Kern und Schale eine Übergangszone aufweisen, die nur aus den Komponenten des Kern- und den Komponenten des Schalenmaterials besteht, und in welcher in Richtung der Schale der Anteil des Kernmaterials allmählich abnimmt und gleichzeitig der Anteil des Schalenmaterials allmählich zunimmt, und worin die in Schritt a) hergestellte Dispersion von Partikeln aus dem Kernmaterial mindestens einen Ausgangsstoff für das Kernmaterial enthält.

2. Verfahren gemäß Anspruch 1, worin der mittlere Durchmesser der Kern/Schale-Nanopartikel von 1 bis 100 nm, vorzugsweise von 3 bis 15 nm, stärker bevorzugt von 4 bis 8 nm beträgt, wobei die Größenbestimmung über TEM erfolgt.

3. Verfahren gemäß Anspruch 1 oder 2, worin der mittlere Durchmesser der Übergangszone von 0,1 bis 5 nm, vorzugsweise von 0,1 bis 2 nm, vorzugsweise von 0,3 bis 1,2 nm beträgt, wobei die Größenbestimmung über TEM erfolgt.

4. Verfahren gemäß einem oder mehreren der Ansprüche 1, 2, oder 3, worin das Kernmaterial und das Schalenmaterial aus der Grupe der II-VI-, IV-VI- und III-V-Halbleitermaterialien ausgewählt werden.

5. Verfahren gemäß einem oder mehreren der Ansprüche 1, 2, 3 oder 4, worin das Kernmaterial und das Schalenmaterial beide jeweils ein II-VI-, IV-VI- oder III-V-Halbleitermaterial sind, die aus Metall- und Nichtmetallkomponenten aufgebaut sind, und ein oder mehrere Ausgangsstoffe für die Metallkomponenten der Schale oder ein oder mehrere Ausgangsstoffe für die Nichtmetallkomponenten der Schale in Schritt c) ausgewählt und in Schritt d) mit der Dispersion der Partikel aus dem Kernmaterial vermischt werden und in Schritt f) die nicht ausgewählten ein oder mehrere Ausgangsstoffe für die Nichtmetallkomponenten oder Metallkomponenten der Schale aus Halbleitermaterial zugeführt werden.

6. Verfahren gemäß einem oder mehreren der Ansprüche 1, 2, 3, 4 oder 5, worin alle Ausgangsstoffe für das Schalenmaterial in Lösung vorliegen und mindestens eine Lösung eines Ausgangsstoffs einen Stabilisator enthält, der über eine funktionelle Gruppe an die Oberfläche der gebildeten Kern/Schale-Partikel binden kann.

7. Verfahren gemäß einem oder mehreren der Ansprüche 1, 2, 3, 4, 5 oder 6, worin die Temperatur in der Reaktionszone des Röhrenreaktors von mehr als 0 bis 380°C, vorzugsweise 25 bis 260 °C, stärker bevorzugt 80 bis 200 °C beträgt.

8. Kern/Schale-Nanopartikel, die einen Kern aus einem Kernmaterial, vorzugsweise einem ersten Halbleitermaterial, und eine äußere Schale aus einem Schalenmaterial umfassen, vorzugsweise aus einem zweiten Halbleitermaterial, **dadurch gekennzeichnet, dass** sich zwischen Kern und Schale nur eine Schicht aus einer Übergangszone befindet, die nur aus den Komponenten des Kern- und den Komponenten des Schalenmaterials besteht, und in welcher in Richtung der Schale der Anteil des Kernmaterials allmählich abnimmt und gleichzeitig der Anteil des Schalenmaterials allmählich zunimmt, wobei der mittlere Durchmesser der Übergangszone von 0,1 bis 5 nm beträgt, wobei die Größenbestimmung über TEM erfolgt.

9. Kern/Schale-Nanopartikel gemäß Anspruch 8, worin der Kern aus einem Halbleitermaterial besteht und die Teilchengrößenverteilung der Nanopartikel derart ist, dass die Standardabweichung in nm vom Mittelwert des Durchmessers der Kern/Schale-Nanopartikel in nm weniger als 20%, vorzugsweise weniger als 15%, stärker bevorzugt weniger als 10%, noch stärker bevorzugt weniger als 7,5% des Mittelwerts beträgt.

10. Kern/Schale-Nanopartikel gemäß Anspruch 8 oder 9, worin der mittlere Durchmesser der Übergangszone von 0,1 bis 1 nm beträgt, und vorzugsweise der mittlere Durchmesser der Kern-Schale-Nanopartikel von 1 bis 100 nm, vorzugsweise von 3 bis 15 nm, stärker bevorzugt von 4 bis 8 nm beträgt, wobei die Größenbestimmung über TEM erfolgt.

11. ern/Schale-Nanopartikel gemäß einem der Ansprüche 8, 9 oder 10, worin das Kernmaterial und das Schalenmaterial jeweils ein Halbleitermaterial sind, vorzugsweise jeweils ein II-VI, IV-VI- oder III-V-Halbleitermaterial.

12. Kern/Schale-Nanopartikel gemäß einem oder mehreren der Ansprüche 8, 9, 10 oder 11, worin die Kern/Schale-Nanopartikel eine Kombination der folgenden Kern/Schalematerialien aufweisen: CdSe/ZnS, CdSe/CdZnS, oder CdSe/CdZnS.

13. Kern/Schale-Nanopartikel gemäß einem oder mehreren der Ansprüche 8, 9, 10, 11 oder 12, worin die Kern/Schale-Nanopartikel durch ein Verfahren erhältlich sind, wie es in einem der Ansprüche 2 bis 8 definiert ist.

14. Verwendung eines Röhrenreaktors zur kontinuierlichen Herstellung von Kern/Schale-Nanopartikeln,
wobei der Reaktor einen von einer Wandung (1) umgebenen röhrenförmigen Hohlraum (2) und eine in dem Hohlraum längs angeordneten Membran (7), welche den Hohlraum in eine Zudosierzone (9) und eine Reaktionszone (10) unterteilt, aufweist,
wobei der Reaktor an einem Ende eine in die Reaktionszone (10) führende Zuleitung (4a) für Mischungen aus Ausgangsmaterial für die Schale und Kernpartikeldispersion und am anderen Ende einen aus der Reaktionszone (10) herausführende Ableitung (4b) für gebildete Kern/Schale-Nanopartikel aufweist,
und wobei entlang des Hohlraums in der Wandung (1) mindestens ein Anschluss (5) für die Zugabe weiteren Ausgangsmaterials für die Schale vorgesehen ist, der in der Zudosierzone mündet.

15. Verwendung nach Anspruch 14, wobei in der Wandung (1) ein weiterer Anschluss (6) für die Abführung überschüssigen Ausgangsmaterials für die Schale vorgesehen ist.

16. Verwendung nach einem der Ansprüche 14 oder 15, wobei die Membran (7) röhrenförmig ist und im Inneren die Reaktionszone ausbildet.

## Claims

1. A process for the continuous preparation of core-shell nanoparticles comprising a core of a core material, preferably of a semiconductor material, and a shell of a shell material, preferably of a semiconductor material,
the process comprising the steps of:
a) preparing a dispersion of nanoparticles of the core material in a solvent,
b) providing all starting materials for the shell material, preferably in dissolved form,
c) the selection of one or more starting materials for the shell material for the step d), the selection being made so that the selected starting materials do not react with each other,
d) mixing the selected starting material or the selected starting materials for the shell material with the dispersion of the nanoparticles from the core material,
e) continuously passing the mixture obtained in step d) through a reaction zone (10) of a tubular reactor,
f) continuously feeding the starting material not selected in step c) or the starting materials not selected in step c) for the shell material at two or more locations to the reaction zone (10),
g) reacting the starting materials for the shell material in the reaction zone (10) to form a shell around the nanoparticles from the core material,
and wherein the reaction zone (10) of the tubular reactor is surrounded by a membrane (7), via which the one or more starting materials for the shell material not selected in step c) are supplied in step f),
wherein the core-shell nanoparticles have a transition zone between the core and shell consisting only of the components of the core material and the components of the shell material, and in which in the direction of the shell, the proportion of the core material gradually decreases and at the same time the proportion of the shell material gradually increases, and wherein the dispersion of particles of the core material produced in step a) contains at least one starting material for the core material.

2. The process according to claim 1, wherein the average diameter of the core-shell nanoparticles is from 1 to 100 nm, preferably from 3 to 15 nm, more preferably from 4 to 8 nm, wherein the size determination is done via TEM.

3. The process according to claim 1 or 2, wherein the average diameter of the transition zone is 0.1 to 5 nm, preferably from 0.1 to 2 nm, preferably of 0.3 to 1.2 nm, wherein the size determination is done via TEM.

4. The process according to one or more of claims 1, 2 or 3, wherein the core material and the shell material are selected from the group of II-VI, IV-VI and III-V semiconductor materials.

5. The process according to one or more of claims 1, 2, 3 or 4, wherein the core material and the shell material both are each a II-VI, IV-VI or III-V semiconductor material, composed of metal and non-metal components, and one or more starting materials for the metal components of the shell or one or more starting materials for the non-metal components of the shell are selected in step c) and mixed in step d) with the dispersion of the particles of the core material and in step f) the non-selected one or more starting materials for the non-metal components or metal components are fed to the shell of semiconductor material.

6. The process according to one or more of claims 1, 2, 3, 4, or 5, wherein all the starting materials for the shell material are present in solution and at least one solution of a starting material contains a stabilizer, which can bind to the surface of the formed core-shell particles via a functional group.

7. The process according to one or more of claims 1, 2, 3, 4, 5, or 6, wherein the temperature in the reaction zone of the tubular reactor is more than 0 to 380 °C, preferably 25 to 260 °C, more preferably 80 to 200 °C.

8. Core-shell nanoparticle comprising a core of a core material, preferably a first semiconductor material, and an outer shell of a shell material, preferably of a second semiconductor material, **characterized in that**, between the core and shell, there is only a layer of a transition zone, consisting only of the components of the core material and the components of the shell material, and in which the proportion of the core material gradually decreases in the direction of the shell, and at the same time the proportion of the shell material gradually increases, wherein the average diameter of the transition zone is 0.1 to 5 nm, wherein the size determination is done via TEM.

9. The core-shell nanoparticles according to claim 8, wherein the core consists of a semiconductor material and the particle size distribution of the nanoparticles is such that the standard deviation in nm from the mean value of the diameter of the core-shell nanoparticles in nm is less than 20%, preferably less than 15%, more preferably less than 10%, even more preferably less than 7.5% of the mean value.

10. The core-shell nanoparticles according to claim 8 or 9, wherein the average diameter of the transition zone is 0.1 to 1 nm, and preferably the average diameter of the core-shell nanoparticles is 1 to 100 nm, preferably 3 to 15 nm, more preferably 4 to 8 nm, wherein the size determination is done via TEM.

11. The core-shell nanoparticles according to any one of claims 8, 9, or 10, wherein the core material and the shell material are each a semiconductor material, preferably each being a II-VI, IV-VI or III-V semiconductor material.

12. The core-shell nanoparticles according to one or more of claims 8, 9, 10 or 11, wherein the core-shell nanoparticles have a combination of the following core-shell materials: CdSe/ZnS, CdSe/CdZnS, or CdSe/CdZnS.

13. The core-shell nanoparticles according to one or more of claims 8, 9, 10, 11 or 12, wherein the core-shell nanoparticles are obtainable by a process as defined in any one of claims 2 to 8.

14. Use of a tubular reactor for the continuous production of core-shell nanoparticles,
wherein the reactor has a tubular cavity (2) surrounded by a wall (1) and a membrane (7) arranged longitudinally in the cavity, which membrane divides the cavity into an addition zone (9) and a reaction zone (10),
wherein the reactor has, at one end, a feeding line (4a) for mixtures of the starting material for the shell and core particle dispersion, which feeding line leads into the reaction zone (10), and, at the other end, a discharge line (4b) for formed core-shell nanoparticles, which discharge line leads out of the reaction zone (10),
and wherein there is provided, along the cavity in the wall (1), at least one connection (5) for adding additional starting material for the shell, which opens into the addition zone.

15. Use according to claim 14, wherein a further connection (6) is provided in the wall (1) for the discharge of excess starting material for the shell.

16. Use according to any one of claims 14 to 15, wherein the membrane (7) is tubular and inside forms the reaction zone.

## Revendications

1. Procédé de production continue de nanoparticules noyau/enveloppe qui comprennent un noyau en matériau de noyau, de préférence en matériau semi-conducteur, et une enveloppe en matériau d'enveloppe, de préférence en matériau semi-conducteur,
dans lequel le procédé comprend les étapes suivantes :
a) la production d'une dispersion de nanoparticules issues du matériau de noyau dans un solvant,
b) la mise à disposition de toutes les matières premières pour le matériau d'enveloppe, de préférence sous forme diluée,
c) la sélection d'une ou plusieurs matières premières pour le matériau d'enveloppe pour l'étape d), dans lequel la sélection a lieu de sorte que les matières premières sélectionnées ne réagissent pas entre elles,
d) le mélange de la matière première sélectionnée ou des matières premières sélectionnées pour le matériau d'enveloppe avec la dispersion des nanoparticules issues du matériau de noyau,
e) le guidage continu du mélange obtenu à l'étape d) à travers une zone de réaction (10) d'un réacteur tubulaire,
f) l'amenée continu de la matière première non sélectionnée à l'étape c) ou des matières premières non sélectionnées à l'étape c) pour le matériau d'enveloppe à deux endroits ou plus de la zone de réaction (10),
g) la réaction des matières premières pour le matériau d'enveloppe dans la zone de réaction (10) en formant une enveloppe autour des nanoparticules issues du matériau de noyau,
et dans lequel la zone de réaction (10) du réacteur tubulaire est entourée par une membrane (7), via laquelle à l'étape f) les une ou plusieurs matières premières non sélectionnées à l'étape c) pour le matériau d'enveloppe sont amenées, dans lequel les nanoparticules noyau-enveloppe présentent entre noyau et enveloppe une zone de transition qui se compose uniquement des composants du matériau de noyau et des composants du matériau d'enveloppe, et dans laquelle dans la direction de l'enveloppe la part du matériau de noyau diminue progressivement et en même temps la part du matériau d'enveloppe augmente progressivement, et dans lequel la dispersion de particules issues du matériau de noyau produite à l'étape a) contient au moins une matière première pour le matériau de noyau.

2. Procédé selon la revendication 1, dans lequel le diamètre moyen des nanoparticules noyau/enveloppe représente de 1 à 100 nm, de préférence de 3 à 15 nm, plus préférablement de 4 à 8 nm, dans lequel le dimensionnement s'effectue par MET.

3. Procédé selon la revendication 1 ou 2, dans lequel le diamètre moyen de la zone de transition représente de 0,1 à 5 nm, de préférence de 0,1 à 2 nm, de préférence de 0,3 à 1,2 nm, dans lequel le dimensionnement s'effectue par MET.

4. Procédé selon l'une quelconque ou plusieurs des revendications 1, 2 ou 3, dans lequel le matériau de noyau et le matériau d'enveloppe sont sélectionnés à partir du groupe des matériaux semi-conducteurs II-VI, IV-VI et III-V.

5. Procédé selon l'une quelconque ou plusieurs des revendications 1, 2, 3 ou 4, dans lequel le matériau de noyau et le matériau d'enveloppe sont tous deux respectivement un matériau semi-conducteur II-VI, IV-VI ou III-V qui sont constitués de composants métalliques et non métalliques, et une ou plusieurs matières premières pour les composants métalliques de l'enveloppe ou une ou plusieurs matières premières pour les composants non métalliques de l'enveloppe sont sélectionnées à l'étape c) et sont mélangées à l'étape d) avec la dispersion des particules issues du matériau de noyau et à l'étape f) les une ou plusieurs matières premières non sélectionnées pour les composants non métalliques ou composants métalliques sont amenées à l'enveloppe en matériau semi-conducteur.

6. Procédé selon l'une quelconque ou plusieurs des revendications 1, 2, 3, 4 ou 5, dans lequel toutes les matières premières pour le matériau d'enveloppe sont présentes en solution et au moins une solution d'une matière première contient un stabilisateur qui peut se lier via un groupe fonctionnel à la surface des particules noyau/enveloppe formées.

7. Procédé selon l'une quelconque ou plusieurs des revendications 1, 2, 3, 4, 5 ou 6, dans lequel la température dans la zone de réaction du réacteur tubulaire représente plus de 0 à 380 °C, de préférence 25 à 260 °C, plus préférablement 80 à 200 °C.

8. Nanoparticules noyau/enveloppe qui comprennent un noyau en matériau de noyau, de préférence un premier matériau semi-conducteur, et une enveloppe externe en matériau d'enveloppe, de préférence en second matériau semi-conducteur, **caractérisées en ce que** seulement une couche issue d'une zone de transition se trouve entre le noyau et l'enveloppe, laquelle se compose uniquement des composants du matériau de noyau et des composants du matériau d'enveloppe, et dans laquelle dans la direction de l'enveloppe la part du matériau de noyau diminue progressivement et en même temps la part du matériau d'enveloppe augmente progressivement, dans lesquelles le diamètre moyen de la zone de transition est de 0,1 à 5 nm, dans lesquelles le dimensionnement s'effectue par MET.

9. Nanoparticules noyau/enveloppe selon la revendication 8, dans lesquelles le noyau se compose d'un matériau semi-conducteur et la répartition des tailles de particules des nanoparticules est telle que l'écart type en nm de la valeur moyenne du diamètre des nanoparticules noyau/enveloppe en nm est inférieure à 20 %, de préférence inférieure à 15 %, plus préférablement inférieure à 10 %, encore plus préférablement inférieure à 7,5 % de la valeur moyenne.

10. Nanoparticules noyau/enveloppe selon la revendication 8 ou 9, dans lesquelles le diamètre moyen de la zone de transition est de 0,1 à 1 nm, et de préférence le diamètre moyen des nanoparticules noyau-enveloppe est de 1 à 100 nm, de préférence de 3 à 15 nm, plus préférablement de 4 à 8 nm, dans lesquelles le dimensionnement s'effectue par MET.

11. Nanoparticules noyau/enveloppe selon l'une quelconque des revendications 8, 9 ou 10, dans lesquelles le matériau de noyau et le matériau d'enveloppe sont respectivement un matériau semi-conducteur, de préférence respectivement un matériau semi-conducteur II-VI, IV-VI ou III-V.

12. Nanoparticules noyau/enveloppe selon l'une quelconque ou plusieurs des revendications 8, 9, 10 ou 11, dans lesquelles les nanoparticules noyau/enveloppe présentent une combinaison des matériaux de noyau/enveloppe suivants : CdSe/ZnS, CdSe/CdZnS ou CdSe/CdZnS.

13. Nanoparticules noyau/enveloppe selon l'une quelconque ou plusieurs des revendications 8, 9, 10, 11 ou 12, dans lesquelles les nanoparticules noyau/enveloppe peuvent être obtenues via un procédé, comme défini dans l'une quelconque des revendications 2 à 8.

14. Utilisation d'un réacteur tubulaire pour la production continue de nanoparticules noyau/enveloppe,
dans laquelle le réacteur présente une cavité tubulaire (2) entourée par une paroi (1) et une membrane (7) disposée longitudinalement dans la cavité, laquelle subdivise la cavité en une zone d'addition dosée (9) et une zone de réaction (10),
dans laquelle le réacteur présente au niveau d'une extrémité une conduite d'amenée (4a) conduisant dans la zone de réaction (10) pour des mélanges de matériau initial pour l'enveloppe et la dispersion de particules de noyau et au niveau d'une autre extrémité une conduite d'évacuation (4b) sortant de la zone de réaction (10) pour des nanoparticules noyau/enveloppe formées,
et dans laquelle le long de la cavité dans la paroi (1) au moins un raccord (5) pour l'ajout d'autre matière première est prévu pour l'enveloppe, qui débouche dans la zone d'addition dosée.

15. Utilisation selon la revendication 14, dans laquelle dans la paroi (1) un autre raccord (6) pour l'enlèvement de matière première excédentaire est prévu pour l'enveloppe.

16. Utilisation selon l'une quelconque des revendications 14 ou 15, dans laquelle la membrane (7) est tubulaire et forme la zone de réaction à l'intérieur.
